(19) Europäisches Patentamt / European Patent Office / Office européen des brevets

(11) **EP 2 269 309 B1**

(12) **FASCICULE DE BREVET EUROPEEN**

(45) Date de publication et mention
de la délivrance du brevet:
**06.11.2013 Bulletin 2013/45**

(21) Numéro de dépôt: **09745935.8**

(22) Date de dépôt: **15.04.2009**

(51) Int Cl.:
***H03K 19/18*** *(2006.01)*

(86) Numéro de dépôt international:
**PCT/FR2009/050691**

(87) Numéro de publication internationale:
**WO 2009/138616 (19.11.2009 Gazette 2009/47)**

(54) **DISPOSITIF MAGNÉTIQUE POUR LA RÉALISATION D'UNE « FONCTION LOGIQUE »**

MAGNETISCHE VORRICHTUNG ZUR AUSFÜHRUNG EINER LOGIKFUNKTION

MAGNETIC DEVICE FOR PERFORMING A "LOGIC FUNCTION"

(84) Etats contractants désignés:
**AT BE BG CH CY CZ DE DK EE ES FI FR GB GR
HR HU IE IS IT LI LT LU LV MC MK MT NL NO PL
PT RO SE SI SK TR**

(30) Priorité: **16.04.2008 FR 0852573**

(43) Date de publication de la demande:
**05.01.2011 Bulletin 2011/01**

(73) Titulaires:
• **Commissariat à l'Énergie Atomique
et aux Énergies Alternatives
75015 Paris (FR)**
• **Centre National de la Recherche Scientifique
75794 Paris (FR)**

(72) Inventeurs:
• **JAVERLIAC, Virgile
F-38370 St Prim (FR)**
• **PRENAT, Guillaume
F-38000 Grenoble (FR)**

(74) Mandataire: **Lebkiri, Alexandre
Cabinet Camus Lebkiri
87 Rue Taitbout
75009 Paris (FR)**

(56) Documents cités:
**WO-A-2004/051853        DE-C1- 10 053 206
US-A1- 2004 213 042**

• **RICHTER R ET AL: "Nonvolatile field
programmable spin-logic for reconfigurable
computing" APPLIED PHYSICS LETTERS, AIP,
AMERICAN INSTITUTE OF PHYSICS, MELVILLE,
NY, vol. 80, no. 7, 18 février 2002 (2002-02-18),
pages 1291-1293, XP012031618 ISSN: 0003-6951**

**EP 2 269 309 B1**

**Description**

La présente invention concerne un dispositif pour la réalisation d'une fonction logique comprenant une structure magnétique comportant au moins un empilement magnétorésistif incluant une première couche ferromagnétique et une deuxième couche ferromagnétique séparées par une couche intercalaire non ferromagnétique. Un exemple pour un tel dispositif est décrit dans le document DE 100 53 206 C1.

L'électronique de spin également désignée par le terme spintronique est une discipline en plein essor, qui consiste à utiliser le spin de l'électron comme degré de liberté supplémentaire par rapport à l'électronique classique sur silicium qui n'utilise que sa charge. Le spin a en effet une influence importante sur les propriétés de transport dans les matériaux ferromagnétiques. De nombreuses applications de l'électronique de spin en particulier les mémoires ou les éléments logiques utilisent des empilements de couches magnétorésistives comprenant au moins deux couches ferromagnétiques séparées par une couche non-magnétique. L'une des couches ferromagnétiques est piégée dans une direction fixe et sert de couche de référence tandis que l'aimantation de l'autre couche peut être commutée relativement facilement par l'application d'un moment magnétique par un champ magnétique ou un courant polarisé en spin.

Ces empilements peuvent être des jonctions tunnels magnétiques (MTJ) lorsque la couche séparatrice est isolante ou des structures dites vannes de spin lorsque la couche séparatrice est métallique. Dans ces structures, la résistance électrique varie en fonction de l'orientation relative des aimantations des deux couches ferromagnétiques.

Les jonctions tunnels magnétiques sont des nanostructures constituées de deux couches ferromagnétiques séparées par une couche d'oxyde. L'aimantation d'une des couches ferromagnétique (appelée couche dure ou « Hard Layer », HL) est fixe. La stabilité de cette couche peut être assurée par sa forme ou par couplage d'échange avec une couche Anti-FerroMagnétique (AFM). L'aimantation de l'autre couche (appelée couche douce ou « Soft Layer », SL) est modulable. La résistance de l'empilement dépend alors de l'orientation relative des deux couches ferromagnétiques : c'est l'effet de Magnéto Résistance Tunnel. Le passage d'une aimantation Parallèle (P) à une aimantation Anti-Parallèle (AP) va présenter un comportement hystérétique et la valeur de la résistance va alors coder l'information contenue dans la jonction.

Dans les matériaux ferromagnétiques, il existe une anisotropie magnétocristalline due aux interactions entre le moment magnétique et le réseau cristallin. Il en résulte une direction dite de facile aimantation dans laquelle l'aimantation va s'aligner naturellement en l'absence de sollicitation extérieure. A cette anisotropie cristalline, une anisotropie de forme va pouvoir s'ajouter, dépendant cette fois ci de la forme de la jonction : par exemple, si l'on utilise une jonction de forme ovale, l'anisotropie de forme va tendre à aligner l'aimantation suivant l'axe le plus grand de la jonction. Si l'axe de facile aimantation magnétocristalline est orienté suivant cette même direction, les effets vont s'additionner et on va obtenir une stabilité importante de la jonction.

Les magnétorésistances géantes à jonction tunnel sont les éléments de stockage d'un nouveau type de mémoires magnétiques non-volatiles. Associées à des matrices d'adressage, elles constituent des mémoires MRAM (« Magnetic Random Access Memory »). La non volatilité intrinsèque des dispositifs magnétiques, alliée à une grande densité d'intégration, une grande vitesse d'écriture et une bonne immunité aux radiations permet d'espérer combiner les qualités de toutes les sortes de mémoires électroniques existantes et d'en dépasser les performances. Dans le cadre d'une utilisation mémoire, les caractéristiques cruciales sont la densité d'intégration, les vitesses et les consommations à l'écriture et à la lecture.

A côté des mémoires de type MRAM, un grand champ d'applications de ces magnétorésistances à effet tunnel est la logique programmable. Un circuit de logique programmable est un circuit dont la fonctionnalité peut être programmée à partir d'un circuit standard. Si cette fonctionnalité peut être modifiée plusieurs fois, on parle de circuits reprogrammables. Les circuits reprogrammables les plus utilisés actuellement sont les FPGA (« Field Programmable Gate Array »), qui sont composés de fonctions logiques programmables de base dites tables de conversion (ou LUT pour « Look Up  Table ») interconnectées pour former une fonction logique complexe. Dans ce type de circuits, la fonction de chaque LUT est codée par un code stocké en mémoire. On peut ainsi concevoir des portes logiques ou autres éléments logiques utilisant des jonctions tunnels ou des vannes de spin. Ces éléments bénéficient du caractère non-volatile de l'information qui y est traitée, et de la possibilité de reprogrammer la porte c'est-à-dire d'en changer la fonctionnalité (par exemple transformer une porte ET en NON OU). Les problématiques de la logique programmable sont donc assez proches de celles des mémoires, avec toutefois quelques nuances :

- La densité d'intégration est moins critique que dans le cas d'une mémoire (car les éléments mémoires de logique programmable ne servent qu'à stocker la fonctionnalité du circuit et non pas une grande quantité de données) ;
- La vitesse et la consommation d'écriture sont également moins critiques, la fonctionnalité du circuit étant alors programmée une fois et le fonctionnement du circuit ne consistant qu'en une suite de cycles de lecture (sauf en cas de reconfiguration dynamique où la fonctionnalité du circuit évolue au cours de son utilisation).

La troisième grande famille de circuits logiques est celle des circuits logiques non reprogrammables ou ASIC's (Application Specific Integrated Circuits). Dans ces circuits, la fonction logique est inchangeable et un circuit doit être conçu pour chaque fonction logique. Cette approche est beaucoup plus performante en terme d'intégration, mais elle nécessite de créer un circuit spécifique, ce qui est beaucoup plus cher que dans une approche reprogrammable. Il n'y a pas ici d'aspect de mémorisation : la fonction logique est généralement décomposée en fonctions logiques élémentaires (« et », « ou » et « complément »), appelées « standard cells » et interconnectées entre elles pour former la fonction logique désirée.

Alors que les MRAMs et les FPGA ont fait l'objet de beaucoup d'études, les travaux sur la logique magnétique non reprogrammable sont beaucoup moins nombreux. En effet, la non-volatilité et l'immunité aux radiations des MTJ les prédisposent davantage à un usage de type mémoire. De plus, ces dispositifs étant passifs, il n'est pas a priori possible de connecter directement deux fonctions logiques purement magnétiques sans détériorer leur fonction, à moins de faire appel à des composants CMOS pour regénérer le signal. Or une fonction logique est généralement décomposée en fonctions logiques élémentaires.

Par ailleurs, dans le cas d'une utilisation de type mémoire ou FGPA, le signal logique n'est transféré d'une technologie à l'autre (magnétique vers CMOS et vice-versa) qu'un faible nombre de fois ; en d'autres termes, le rapport entre le nombre de composants magnétiques et le nombre de composants CMOS est suffisamment grand pour rendre l'approche viable. En revanche, si l'on cherche à réaliser une fonction complexe à partir de fonctions logiques élémentaires, le signal logique doit traverser un nombre important de cellules logiques de base, nécessitant à chaque fois un double changement de technologie, le nombre de ces changements devenant rapidement prohibitif. On peut également exprimer cela en disant que le rapport mentionné ci-dessus entre le nombre de composants magnétiques et les nombre de composants CMOS peut vite devenir inacceptable et l'intérêt d'utiliser des composants magnétiques devient discutable.

Dans ce contexte, la présente invention a pour but de fournir un dispositif permettant la réalisation de fonctions logiques non reprogrammables à partir d'une structure magnétique en s'affranchissant des problèmes cités plus haut.

A cette fin, l'invention propose un dispositif pour la réalisation d'une « fonction logique » comprenant une structure magnétique comportant :

- au moins un premier empilement magnétorésistif incluant une première couche ferromagnétique et une deuxième couche ferromagnétique séparées par une couche intercalaire non ferromagnétique, la deuxième couche étant une couche ferromagnétique douce tandis que la première couche est une couche ferromagnétique dure piégée dans un état magnétique fixe servant de référence,
- au moins une première ligne de courant située au voisinage dudit premier empilement magnétorésistif et engendrant au voisinage dudit premier empilement un champ magnétique lorsqu'elle est traversée par un courant électrique,

ladite première ligne comportant, pour ledit au moins un empilement, au moins deux points d'entrées de courant de sorte que deux courants s'additionnent dans ladite première ligne, la somme desdits deux courants étant déterminée par ladite fonction logique,
ledit dispositif étant caractérisé en ce que ladite première ligne est connectée à au moins une autre ligne de courant appartenant à un niveau de métallisation différent du niveau de métallisation de ladite première ligne les deux lignes étant reliées par une ligne conductrice d'interconnexion et le point de connexion entre ladite ligne d'interconnexion et ladite première ligne formant l'un desdits deux points d'entrée de courant.

On entend par « fonction logique » une fonction ayant un seuil minimum de complexité booléenne équivalent à l'une au moins des quatre fonctions « ET », « OU », « NON ET » ou « NON OU ». Par conséquent, le fait d'inscrire ou de lire une mémoire n'est pas considéré comme une fonction logique au sens de l'invention.

Par ailleurs, conformément à l'usage, un élément magnétorésistif qui comporte au moins une couche ferromagnétique dure et une couche ferromagnétique douce séparées par une couche intercalaire non ferromagnétique (métallique ou isolante) est appelé « empilement magnétorésistif » ou « jonction tunnel magnétique ». Dans ce qui suit, on désignera cet élément par le terme « empilement magnétorésistif ».

Dans de tels empilements, l'une ou l'autre des couches ferromagnétiques, ou les deux, peuvent être elles-mêmes composées de plusieurs couches ferromagnétiques et non ferromagnétiques conçues de telle manière que l'ensemble se comporte comme une seule couche ferromagnétique de performances améliorées, formant ce que l'on appelle une couche magnétique de synthèse. Dans ce qui suit, on écrira indifféremment « couche magnétique » ou « couche ferromagnétique ».

Grâce à l'invention, on génère une fonction logique en utilisant un empilement magnétorésistif à écriture par champ et en interconnectant des entrées (éventuellement reliées à des lignes) portant différents signaux de courant de manière à produire la fonction logique par la somme des courants (Lois de Kirchhoff) et non directement par la somme des champs magnétiques (impliquant plusieurs lignes d'écriture au voisinage de l'empilement). Le dispositif selon l'invention comprend des entrées (éventuellement reliées à des lignes) de courant regroupées ensemble en une seule ligne d'écriture ; une telle configuration est particulièrement utile lorsqu'on a beaucoup d'entrées ; on évite ainsi d'avoir beaucoup de lignes de courant autour d'un même empilement.

On notera que les lignes de courant peuvent avoir des formes diverses de type fil ou ruban.

On notera qu'il est également possible de prendre des lignes de largeurs différentes de sorte que, à courant égal et à distance de la couche ferromagnétique égale, le champ magnétique généré par une ligne plus large soit plus faible que le champ magnétique généré par une ligne moins large.

Le dispositif selon l'invention peut également présenter une ou plusieurs des caractéristiques ci-dessous, considérées individuellement ou selon toutes les combinaisons techniquement possibles :

- lesdits au moins deux points d'entrées de courant injectent respectivement un courant $I_1$ et $I_2$ dans ladite troisième ligne de sorte que l'intensité H' du champ généré par ladite troisième ligne au voisinage de ladite couche douce est

telle que $\dfrac{H^{'}}{H} = \dfrac{I_1 + I_2}{I}$ où H est l'intensité du champ magnétique généré par ladite troisième ligne de courant lorsque celle-ci est parcourue par un courant 1 ;

- le dispositif selon l'invention comporte :

    o au moins un deuxième empilement magnétorésistif qui peut être soit confondu avec ledit premier empilement soit différent dudit premier empilement, ledit deuxième empilement incluant une première couche ferromagnétique et une deuxième couche ferromagnétique séparées par une couche intercalaire non ferromagnétique,
    o au moins deux lignes de courant appartenant respectivement à un premier et un deuxième niveau de métallisation, chacune desdites deux lignes engendrant un champ magnétique au voisinage dudit deuxième empilement lorsqu'elles sont traversées par un courant électrique,

    lesdites deux lignes étant disposées à des distances différentes de ladite deuxième couche ferromagnétique dudit deuxième empilement ; on entend par distance entre une ligne et la deuxième couche la distance séparant le centre de la deuxième couche et le point de la ligne le plus proche dudit centre de la deuxième couche. La deuxième couche sera le plus souvent une couche ferromagnétique douce tandis que la première couche sera le plus souvent une couche ferromagnétique dure piégée dans un état magnétique fixe servant de référence. On notera que les axes de symétrie des lignes de courant dans le sens du courant et le centre de la deuxième couche ne sont pas nécessairement dans un même plan: on parle dans ce cas d' « offset » spatial. De façon analogue aux circuits intégrés semiconducteurs, le dispositif selon ce mode de réalisation de l'invention est réalisé par une pluralité de couches d'interconnexion comprenant une alternance de couches conductrices aussi appelées "niveaux de métallisation" pourvues de lignes conductrices métallisées s'étendant parallèlement à ladite couche et de couches isolantes traversées par des vias conducteurs permettant une connexion électrique entre deux niveaux de métallisation. Un niveau de métallisation comprend une pluralité de lignes conductrices entourées par des régions réalisées en matériau diélectrique. Jouer sur la distance entre la ligne d'écriture et la couche douce va permettre de pondérer l'effet d'un courant par rapport à un autre courant dans une autre ligne et permettre de contribuer à la génération de fonction logique. Dans tous les dispositifs connus (cellules type mémoire par exemple), la distance de la ligne à l'empilement magnétorésistif est fixe et minimale pour des questions de densité de courant. A contrario, selon ce mode de réalisation de l'invention, on va moduler l'amplitude du champ magnétique en prenant une topologie d'interconnexion avec des distances différentes entre la couche douce et les lignes, la somme des effets de chaque ligne se traduisant par la somme des champs magnétiques générés. La topologie d'interconnexion va donc consister à placer judicieusement les lignes d'écriture autour de l'empilement magnétorésistif afin d'y appliquer le champ magnétique total nécessaire pour orienter l'aimantation de la couche douce par rapport à celle de la couche dure de manière à ce que la résistance tunnel résultante code l'information voulue. Ce mode de réalisation permet d'éviter les problèmes d'interconnexions de fonctions logiques élémentaires en utilisant la topologie des lignes d'écriture (choix ad hoc de la direction des lignes par rapport aux empilements magnétorésistifs, du sens du courant les parcourant et de la distance entre ces lignes et les empilements)..

- lesdites deux lignes sont situées de part et d'autre dudit deuxième empilement magnétorésistif ;
- l'une desdites deux lignes est située à une distance d1 au dessus de ladite deuxième couche et l'autre desdites deux lignes est située à une distance d2 au dessous de ladite deuxième couche, de sorte que, pour deux courants de même intensité circulant respectivement dans l'une et l'autre desdites deux lignes, les intensités H1 et H2 des champs générés respectivement par la ligne située à la distance d1 et par la ligne située à la distance d2 au voisinage de ladite deuxième couche soient telles que : $\dfrac{H_1}{H_2} = \dfrac{d_2}{d_1}$ ;

- le dispositif selon l'invention comporte :

  o au moins un empilement magnétorésistif incluant une première couche ferromagnétique et une deuxième couche ferromagnétique séparées par une couche intercalaire non ferromagnétique,
  o au moins deux lignes de courant appartenant respectivement à un premier et un deuxième niveau de métallisation, chacune desdites deux lignes engendrant un champ magnétique au voisinage dudit au moins un empilement lorsqu'elles sont traversées par un courant électrique,

  lesdites deux lignes étant disposées à égale distance de part et d'autre de ladite deuxième couche ferromagnétique ;

- la ou les premières couches ferromagnétiques sont des couches ferromagnétiques dures piégées dans un état magnétique fixe qui sert de référence et la ou les deuxièmes couches ferromagnétiques sont des couches ferromagnétiques douces ;
- la ou les couches douces présentent une forme circulaire ou quasi-circulaire de façon à minimiser le courant d'écriture nécessaire à la modulation de leur orientation magnétique ;
- la couche dure de chacun des empilements magnétorésistifs est piégée dans un état magnétique perpendiculaire à un axe de facile aimantation servant de référence pour la couche douce du même empilement, cette couche douce de l'empilement magnétorésistif présentant une orientation magnétique modulable par le courant issue de la ou des lignes de courant située(s) au voisinage de l'empilement magnétorésistif de manière à induire une modification de la résistance transversale de l'empilement suffisante pour déclencher un signal électrique, cette modulation de l'orientation magnétique de la couche douce de l'empilement étant suffisamment faible pour que cette orientation ne bascule pas entre deux positions stables mais fluctue autour d'une position stable.
- le dispositif selon l'invention comporte une interface d'entrée comportant :

  o au moins une entrée recevant une information logique codifiée sous la forme d'un niveau de tension représentant un '0' ou un '1' logique ;
  o au moins une sortie reliée à une ligne conductrice d'interconnexion ;
  o des moyens électroniques pour générer dans ladite ligne conductrice d'interconnexion un courant dont le sens est représentatif de l'information logique, la valeur absolue de l'intensité dudit courant étant identique dans un sens ou dans l'autre dudit courant ;

- le dispositif selon l'invention comporte une interface de sortie reliée électriquement au dit au moins un premier empilement magnétorésistif, ladite interface comportant :

  o une entrée reliée à une ligne conductrice d'interconnexion reliant électriquement ladite entrée au dit au moins un premier empilement magnétorésistif ;
  o des moyens pour mesurer le courant circulant dans ledit au moins un premier empilement, courant représentatif de l'état magnétique dudit au moins premier empilement ;
  o des moyens pour générer une tension représentative dudit état magnétique en fonction dudit courant ;

- le dispositif selon l'invention comporte :

  o un deuxième empilement magnétorésistif incluant une première couche ferromagnétique et une deuxième couche ferromagnétique séparées par une couche intercalaire non ferro-magnétique ;
  o une interface de sortie reliée électriquement aux dits premier et deuxième empilements magnétorésistifs, ladite interface comportant :

    ■ une première entrée reliée à une ligne conductrice d'interconnexion reliant électriquement ladite première entrée au dit premier empilement magnétorésistif ;
    ■ une deuxième entrée reliée à une ligne conductrice d'interconnexion reliant électriquement ladite deuxième entrée au dit deuxième empilement magnétorésistif ;
    ■ des moyens pour générer un courant différentiel entre le courant circulant dans ledit premier empilement et le courant circulant dans ledit deuxième empilement lorsque ceux-ci sont soumis à une tension de polarisation, ledit courant différentiel étant représentatif d'une information logique ;
    ■ des moyens pour générer une tension représentative de ladite information logique en fonction dudit courant différentiel ;

- ladite interface d'entrée et/ou de sortie est réalisée en technologie CMOS;

- ladite structure magnétique est située au-dessus de la ou desdites interfaces réalisée(s) en technologie CMOS ;
- la ou les couches de jonction intercalaire non ferromagnétiques sont réalisées en oxyde de magnésium MgO ;
- le dispositif selon l'invention comporte au moins deux lignes de largeurs différentes situées au voisinage d'un empilement magnétorésistif.

La présente invention a également pour objet un premier additionneur incorporant un dispositif selon l'invention, ledit additionneur comprenant :

- une interface d'entrée de signaux de courant $I_A$, $I_B$ et $I_{Cin}$ alimentant trois lignes d'interconnexions,

- une structure magnétique comprenant :

   o une partie magnétique de génération de ladite somme,

   o une partie magnétique de génération de ladite retenue,

ladite partie magnétique de génération de ladite retenue comportant :

- un premier empilement magnétorésistif incluant une couche ferromagnétique dure et une couche ferromagnétique douce séparées par une couche intercalaire non ferromagnétique, la couche ferromagnétique dure étant piégée dans un état magnétique fixe qui sert de référence,
- un deuxième empilement magnétorésistif incluant une couche ferromagnétique dure et une couche ferromagnétique douce séparées par une couche intercalaire non ferromagnétique, la couche ferromagnétique dure étant piégée dans un état magnétique fixe qui sert de référence,
- une première ligne de courant engendrant un champ magnétique au voisinage desdits premier et deuxième empilement et étant située à une distance d suivant l'axe vertical des couches douces de chacun desdits premier et troisième empilement,
- un premier et un deuxième via conducteur vertical reliant électriquement ladite première ligne de courant respectivement à une deuxième ligne de courant parcourue par le courant $I_A$ et à une branche d'une troisième ligne de courant parcourue par la somme des courants $I_B+I_{Cin}$ de sorte que les courants $I_B+I_{Cin}$ et $I_A$ soient sommés avant d'être acheminés sur ladite première ligne de courant engendrant un champ magnétique au voisinage desdits premier et deuxième empilements.

Avantageusement, ladite partie magnétique de génération de ladite somme comporte :

- un troisième empilement magnétorésistif incluant une couche ferromagnétique dure et une couche ferromagnétique douce séparées par une couche intercalaire non ferromagnétique, la couche ferromagnétique dure étant piégée dans un état magnétique fixe qui sert de référence,
- un quatrième empilement magnétorésistif incluant une couche ferromagnétique dure et une couche ferromagnétique douce séparées par une couche intercalaire non ferromagnétique, la couche ferromagnétique dure étant piégée dans un état magnétique fixe qui sert de référence,
- une troisième et quatrième ligne de courant, lesdites deuxième, troisième et quatrième lignes de courant appartenant respectivement à un premier, un deuxième et un troisième niveau de métallisation,
- un troisième, un quatrième et un cinquième via conducteur vertical d'accès à ladite interface d'entrée connectés électriquement respectivement auxdites deuxième, troisième et quatrième ligne de courant de sorte que ledit troisième via vertical injecte le courant $I_B$ dans ladite troisième ligne, ledit quatrième via vertical injecte le courant $I_A$ dans ladite deuxième ligne et ledit cinquième via vertical injecte le courant $I_{Cin}$ dans ladite quatrième ligne de courant,

ladite deuxième ligne de courant engendrant un champ magnétique au voisinage desdits troisième et quatrième empilement et étant située à une distance d suivant l'axe vertical des couches douces de chacun desdits troisième et quatrième empilement,
ladite troisième ligne de courant engendrant un champ magnétique au voisinage dudit troisième empilement et étant située à une distance 2xd suivant l'axe vertical de la couche douce dudit troisième empilement,
ladite quatrième ligne de courant engendrant un champ magnétique au voisinage desdits troisième et quatrième empilement et étant située à une distance 2xd suivant l'axe vertical des couches douces de chacun desdits troisième et quatrième empilement,
ladite troisième ligne de courant étant reliée électriquement à ladite quatrième ligne de courant grâce à un via d'interconnexion vertical de sorte que les courants $I_B$ et $I_{Cin}$ desdites troisième et quatrième lignes soient sommés avant d'être acheminés sur la branche de ladite quatrième ligne de courant engendrant un champ magnétique au voisinage dudit quatrième empilement,

ladite deuxième ligne de courant étant sensiblement perpendiculaire aux dites troisième et quatrième lignes de courant au voisinage dudit troisième empilement et ladite deuxième ligne de courant étant sensiblement perpendiculaire à ladite quatrième ligne de courant au voisinage dudit quatrième empilement.

La présente invention a également pour objet un second additionneur incorporant un dispositif selon l'invention comprenant :

- une interface d'entrée de signaux de courant $I_{A0}$, $I_{B0}$ et $I_{Cin0}$ alimentant trois lignes d'interconnexions,

- une structure magnétique comprenant :

o une partie magnétique de génération de ladite somme comportant :

■ un premier empilement magnétorésistif incluant une couche ferromagnétique dure et une couche ferro-magnétique douce séparées par une couche intercalaire non ferromagnétique, la couche ferromagnétique dure étant piégée dans un état magnétique fixe qui sert de référence,
■ un deuxième empilement magnétorésistif incluant une couche ferromagnétique dure et une couche ferromagnétique douce séparées par une couche intercalaire non ferromagnétique, la couche ferromagnétique dure étant piégée dans un état magnétique fixe qui sert de référence,
■ une première, une deuxième et une troisième ligne de courant appartenant respectivement à un premier, un deuxième et un troisième niveau de métallisation,
■ un premier, un deuxième et un troisième via conducteur vertical d'accès à ladite interface d'entrée connectés électriquement respectivement auxdites première, deuxième et troisième ligne de courant de sorte que le premier via vertical injecte le courant $I_B$ dans ladite première ligne, ledit deuxième via vertical injecte le courant $I_A$ dans ladite deuxième ligne et ledit troisième via vertical injecte le courant $I_{Cin}$ dans ladite troisième ligne,

ladite deuxième ligne de courant engendrant un champ magnétique au voisinage desdits premier et deuxième empilement et étant située à une distance d suivant l'axe vertical des couches douces de chacun desdits premier et deuxième empilement,

ladite première ligne de courant engendrant un champ magnétique au voisinage dudit premier empilement et étant située à une distance 2xd suivant l'axe vertical de la couche douce dudit premier empilement,

ladite troisième ligne de courant engendrant un champ magnétique au voisinage desdits premier et deuxième empilement et étant située à une distance 2xd suivant l'axe vertical des couches douces de chacun desdits premier et deuxième empilement,

ladite première ligne de courant étant reliée électriquement à ladite troisième ligne de courant grâce à un via d'interconnexion vertical de sorte que les courants $I_B$ et $I_{Cin}$ desdites première et troisième lignes soient sommés avant d'être acheminés sur la branche de ladite troisième ligne de courant engendrant un champ magnétique au voisinage dudit deuxième empilement,

ladite deuxième ligne de courant étant sensiblement perpendiculaire aux dites première et troisième lignes de courant au voisinage dudit premier empilement et ladite deuxième ligne de courant étant sensiblement perpendiculaire à ladite troisième ligne de courant au voisinage dudit deuxième empilement,

o une quatrième ligne de courant, dite ligne de propagation de retenue, appartenant au dit premier niveau de métallisation,

o un quatrième et un cinquième via conducteur vertical reliant électriquement ladite quatrième ligne de courant respectivement à ladite deuxième ligne de courant parcourue par le courant $I_A$ et à ladite branche de ladite troisième ligne de courant parcourue par la somme des courants $I_B+I_{Cin}$ de sorte que les courants $I_B+I_{Cin}$ et $I_A$ soient sommés avant d'être acheminés sur ladite quatrième ligne de courant,

o une cinquième ligne de courant appartenant à un niveau de métallisation différent dudit premier niveau de métallisation et apte à produire un champ magnétique au voisinage d'un empilement magnétorésistif,

o un sixième via conducteur vertical reliant électriquement ladite quatrième ligne de courant à ladite cinquième ligne de courant.

Avantageusement, le second additionneur comporte :

- un septième via conducteur vertical reliée électriquement à ladite ligne de propagation de retenue;
- un circuit limiteur de courant pour limiter la valeur absolue du courant circulant dans ladite ligne de propagation de retenue, ledit circuit limiteur de courant étant relié à ladite ligne de propagation par ledit septième via conducteur.

Préférentiellement, ledit circuit limiteur comporte trois transistors PMOS et trois transistors NMOS montés en série, le premier transistor PMOS et le troisième transistor NMOS ayant leur grille commune, le deuxième transistor PMOS et le deuxième transistor NMOS ayant leur grille commune, le troisième transistor PMOS et le premier transistor NMOS ayant leur grille commune, le drain commun du premier transistor NMOS et du troisième transistor PMOS étant connecté à ladite ligne de propagation de la retenue par ledit septième via conducteur vertical.

La présente invention a également pour objet une porte « et » logique incorporant un dispositif selon l'invention, ladite porte « et » comprenant :

- une interface d'entrée de signaux de courant $I_A$ et $I_B$,

- une structure magnétique comprenant :

    o un empilement magnétorésistif incluant une couche ferromagnétique dure et une couche ferromagnétique douce séparées par une couche intercalaire non ferromagnétique, la couche ferromagnétique dure étant piégée dans un état magnétique fixe qui sert de référence,

    o une première, une deuxième, une troisième et une quatrième ligne de courant,

ladite première ligne de courant recevant le courant $I_A$,
ladite deuxième ligne de courant recevant le courant $I_B$,
ladite troisième ligne de courant recevant un courant constant prédéterminé, ladite quatrième ligne de courant étant située au voisinage dudit empilement magnétorésistif et engendrant au voisinage dudit empilement un champ magnétique lorsqu'elle est traversée par un courant électrique, ladite quatrième ligne de courant comportant trois points d'entrées de courant la reliant électriquement auxdites première, deuxième et troisième lignes de courant de sorte que les courants circulant dans lesdites première, deuxième et troisième lignes de courant s'additionnent dans ladite quatrième ligne.

La présente invention a enfin pour objet un dispositif voteur majoritaire incorporant un dispositif selon l'invention, ledit dispositif voteur majoritaire comprenant :

- une interface d'entrée de signaux de courant $I_a$, $I_b$ et $I_c$ alimentant trois lignes d'interconnexions,

- une structure magnétique comprenant une partie magnétique de génération de la sortie dudit voteur majoritaire comportant :

    o un premier empilement magnétorésistif incluant une couche ferromagnétique dure et une couche ferromagnétique douce séparées par une couche intercalaire non ferromagnétique, la couche ferromagnétique dure étant piégée dans un état magnétique fixe qui sert de référence,
    o un deuxième empilement magnétorésistif incluant une couche ferromagnétique dure et une couche ferromagnétique douce séparées par une couche intercalaire non ferromagnétique, la couche ferromagnétique dure étant piégée dans un état magnétique fixe qui sert de référence,
    o une première ligne de courant engendrant un champ magnétique au voisinage desdits premier et deuxième empilement et étant située à une distance d suivant l'axe vertical des couches douces de chacun desdits premier et troisième empilement,
    o un premier et un deuxième via conducteur vertical reliant électriquement ladite première ligne de courant respectivement à une deuxième ligne de courant parcourue par le courant $I_a$ et à une branche d'une troisième ligne de courant parcourue par la somme des courants $I_b+I_c$ de sorte que les courants $I_b+I_c$ et la soient sommés avant d'être acheminés sur ladite première ligne de courant engendrant un champ magnétique au voisinage desdits premier et deuxième empilements.

D'autres caractéristiques et avantages de l'invention ressortiront clairement de la description qui en est donnée ci-dessous, à titre indicatif et nullement limitatif, en référence aux figures annexées, parmi lesquelles :

- la figure 1 est une représentation schématique simplifiée du champ magnétique généré par une ligne de courant infiniment longue;
- les figures 2a) et 2b) représentent un empilement magnétorésistif et un fil conducteur rectiligne de longueur infinie ;
- la figure 3 représente un additionneur complet binaire sur 1 bit;
- la figure 4 représente un additionneur complet binaire sur n bits ;
- la figure 5 illustre l'architecture d'un dispositif pour la réalisation d'une fonction logique du type additionneur selon l'invention ;
- les figures 6 a) à 6 b) illustre un mode de réalisation d'une interface d'entrée du dispositif de la figure 5 ;
- la figure 7 illustre un mode de réalisation d'une interface de sortie du dispositif de la figure 5 ;
- la figure 8 représente une vue en trois dimensions d'un mode de réalisation des parties magnétiques de génération de somme et de retenue du dispositif de la figure 5 ;
- les figures 9 et 10 représentent respectivement une vue de dessus et une vue de face de la partie magnétique de génération de somme telle que représentée en figure 8 ;
- la figure 11 représente une vue de dessus de la partie magnétique de génération de retenue telle que représentée en figure 8 ;
- la figure 12 représente une vue en trois dimensions d'un additionneur 2 bits selon l'invention avec propagation de la retenue ;
- la figure 13 représente un circuit limiteur de courant utilisé pour l'additionneur 2 bits de la figure 12 ;
- La figure 14 représente de manière schématique un dispositif pour la réalisation d'une porte « et » logique selon l'invention.

Dans toutes les figures, les éléments communs portent les mêmes numéros de référence.

Afin d'illustrer la notion de topologie d'interconnexion, nous allons tout d'abord quantifier le champ magnétique généré en un point de l'espace par une distribution de courant. Soit une densité de courant locale $\vec{j}$ en un point M' de l'espace repéré par son vecteur position $\vec{r}'$. Le champ magnétique généré par $\vec{j}(\vec{r}')$ en un point M repéré par son vecteur position $\vec{r}'$ est donné par la loi de Biot et Savart :

$$d\vec{H}(\vec{r}) = \frac{\vec{j}(\vec{r}') \times (\vec{r} - \vec{r}')}{4\pi|\vec{r} - \vec{r}'|^3} \qquad (1).$$

On notera que le signe x désigne le produit vectoriel.

Le champ magnétique total obtenu pour une distribution de densités de courant V est obtenue en intégrant cette équation sur tout le volume V :

$$\vec{H}(\vec{r}) = \iiint_V \frac{\vec{j}(\vec{r}') \times (\vec{r} - \vec{r}')}{4\pi|\vec{r} - \vec{r}'|^3} dV \qquad (2).$$

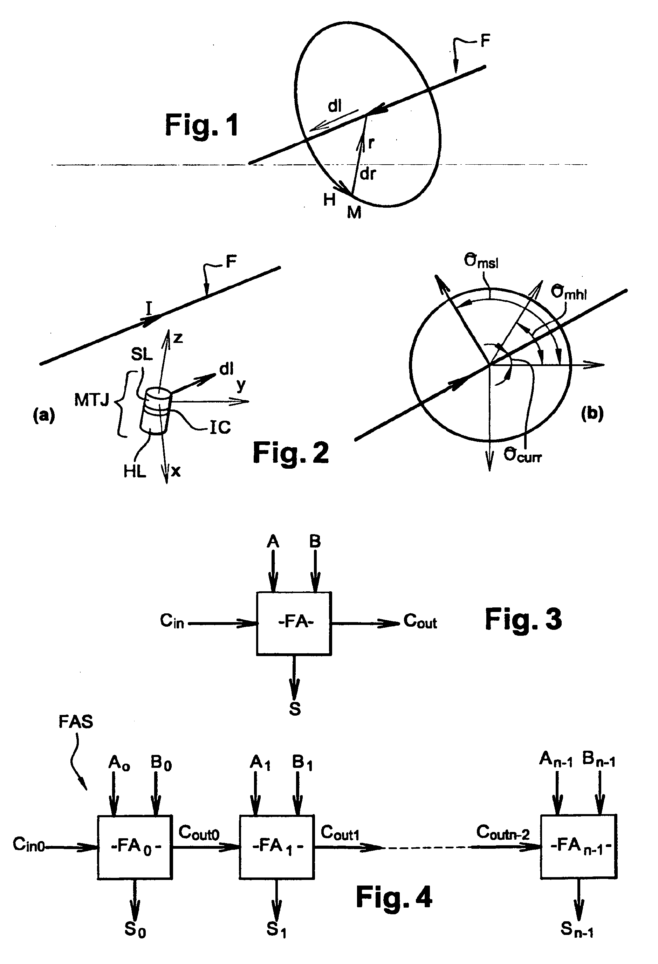

Dans un but de simplification, nous assimilerons dans ce qui suit la ligne d'écriture à un fil de longueur infinie et nous considèrerons le cas d'un champ magnétique généré par ce fil de longueur infinie parcouru par un courant I. La section circulaire du fil est de rayon R. Comme illustré en figure 1, le fil F passe à une distance *r* d'un point M telle que r»R, où $\vec{dl}$ est un vecteur unitaire ayant la direction et le sens du courant et $\vec{dr}$ est un vecteur unitaire perpendiculaire à la ligne de courant et passant par M. Dans ce cas précis, la valeur du champ $\vec{H}$ en M est donnée par l'équation suivante :

$$\vec{H} = \frac{I}{2\pi r} d\vec{r} \times d\vec{l} \qquad (3).$$

On peut déjà noter que dans cette approximation, la valeur du champ dépend de la direction, du sens et de la valeur du courant, ainsi que de la distance de la ligne au point considéré.

Considérons maintenant par exemple que le point M représente le centre de la couche ferromagnétique douce SL d'un empilement magnétorésistif MTJ tel que représenté en figures 2 a) comportant en outre une couche ferromagnétique dure HL et une couche intercalaire non ferromagnétique IC séparant les couches SL et HL. La ligne de courant F est toujours parcourue par un courant I. Avec les conventions de la figure 2 b) où $\theta_{curr}$, $\theta_{mst}$ et $\theta_{mhl}$ sont les angles formés respectivement par la ligne de courant F, l'aimantation de la couche douce SL et l'aimantation de la couche dure HL avec l'axe de facile aimantation de la couche douce (situé suivant l'axe y d'un repère xyz dans lequel l'axe x est perpendiculaire à y dans le plan de la feuille et z est perpendiculaire au plan de la feuille). Le champ magnétique appliqué au centre de la couche douce est donné par l'équation suivante :

$$\vec{H} = \frac{I}{2\pi r} d\vec{r} \times d\vec{l} = \frac{I}{2\pi r} \begin{pmatrix} -\cos\theta_{curr} \\ -\sin\theta_{curr} \\ 0 \end{pmatrix} \qquad (4)$$

Si l'on considère que l'on n'a pas d'anisotropie de forme et que le champ d'anisotropie magnétocristalline est négligeable par rapport au champ appliqué, on peut considérer en première approximation que le moment magnétique sera aligné sur le champ généré.

Si l'on considère l'exemple où l'aimantation de la couche dure est perpendiculaire à l'axe de facile aimantation (i.e. $\theta_{mhl}$ =90°), on peut alors facilement choisir la direction des courants à appliquer pour obtenir des états parallèle (noté P), antiparallèle (noté AP) ou intermédiaire (noté INT) de l'empilement magnétorésistif comme illustré dans le tableau 1 ci-dessous (on désigne par $R_P$ la résistance de l'empilement magnétorésistif MTJ dans son état parallèle, $R_{AP}$ la résistance de l'empilement magnétorésistif dans son état antiparallèle et $R_{INT}$ la résistance de l'empilement magnétorésistif dans un état intermédiaire tel que $R_{AP} > R_{INT} > R_P$).

Tableau 1

| $\theta_{curr}$ | $\theta_{msl}$ | Etat | Résistance de l'empilement magnétorésistif |
|---|---|---|---|
| 0 | 90° | Parallèle | $R_P$ |
| 180° | 270° | Antiparallèle | $R_{AP}$ |
| 90° | 180° | Intermédiaire | $R_{INT}$ |

Supposons maintenant que l'on ait deux lignes de courant $L_1$ et $L_2$, se trouvant respectivement à des distances $r_1$ et $r_2$ du centre de la couche douce, on générera un champ dont la valeur est donnée par l'équation suivante :

$$\vec{H} = \frac{I}{2\pi r} d\vec{r} \times d\vec{l} = \frac{I_1}{2\pi r_1} \begin{pmatrix} -\cos\theta_{curr}^1 \\ -\sin\theta_{curr}^1 \\ 0 \end{pmatrix} + \frac{I_2}{2\pi r_2} \begin{pmatrix} -\cos\theta_{curr}^2 \\ -\sin\theta_{curr}^2 \\ 0 \end{pmatrix} \qquad (5),$$

où $\theta_{curr}^1$ et $\theta_{curr}^2$ sont les angles formés respectivement par les deux lignes de courant $L_1$ et $L_2$ avec l'axe de facile aimantation de la couche dure.

En appliquant ce qui précède à deux lignes, la première ligne étant située à une distance $d_1$ au dessus de la couche douce et la deuxième ligne étant située à une distance $d_2$ au dessous de la couche douce, pour deux courants de même intensité circulant respectivement dans la première ligne et dans la deuxième ligne, les intensités H1 et H2 des champs générés respectivement par les première et deuxième lignes au voisinage de la couche douce sont donc telles que : $\dfrac{H_1}{H_2} = \dfrac{d_2}{d_1}$.

Ainsi, le choix de la direction des deux lignes de courant, de la direction et de l'intensité des deux courants les traversant permet de choisir exactement la direction et l'intensité du champ magnétique généré et donc la direction de l'aimantation sous champ. Cette approche peut être généralisée à n fils conducteurs. Cet exemple n'est bien entendu donné qu'à titre d'illustration: d'une manière générale, tout choix de la position des lignes dans les trois dimensions (se traduisant par un choix de topologie des couches d'interconnexion), de la direction et de la valeur de chaque courant peut être utilisé pour réaliser une fonction logique plus ou moins complexe comme nous allons le voir en détails dans ce qui suit à partir de deux exemples de réalisation d'un circuit logique additionneur magnétique complet (« Magnetic full adder » en anglais) : on entend par additionneur magnétique complet un additionneur qui contient une entrée et une sortie de retenue de sorte qu'il peut être interfacé avec un autre additionneur magnétique complet.

Par ailleurs, l'intensité du champ magnétique généré dépend directement de l'intensité du courant qui traverse la ligne. Dès lors, en additionnant des courants d'entrée arrivant sur une même ligne par une interconnexion ad hoc de plusieurs lignes conductrices arrivant sur ladite ligne (lois de Kirchhoff), on peut modifier la valeur de l'intensité du champ magnétique, l'intensité d'un champ généré étant ainsi par exemple deux fois plus élevée pour une ligne parcourue par un courant 2xI que pour une ligne située à la même distance de la couche douce et parcourue par un courant I.

De façon connue, les processeurs contiennent quatre systèmes fonctionnels:

- les circuits mémoire (code, données),

- les circuits de contrôle (les arbitres de bus, les blocs de gestion de l'énergie,...),

- les circuits d'entrée-sortie permettant les dialogues entre circuits du processeur (« on-chip ») ou avec des circuits externes (« off-chip »),

- le noyau du processeur appelé « core » ou « datapath » dédié au traitement de l'information (i.e. réalisant le calcul à proprement parler).

Le noyau "standard" d'un processeur est généralement constitué d'un ensemble de blocs fonctionnels interconnectés, réalisant des opérations combinatoires basiques purement logiques (« ET », « OU »,...) ou arithmétiques (addition, multiplication, comparaison, décalage), l'ensemble étant piloté par des blocs de contrôle. En fonction de l'application visée, on privilégiera la vitesse du noyau (temps de calcul pour réaliser une opération donnée, la vitesse étant souvent dépendante du type d'opération selon les chemins plus ou moins critiques dans le noyau et du type de données à traiter) ou l'énergie maximale à dissiper pour une opération donnée. Une grande partie des noyaux actuels travaillent sur des mots de 32 bits ou 64 bits. Une même opération devant être effectuée sur chacun des bits du mot, le noyau est donc constitué (pour un mot de 32 bits par exemple) de 32 tranches (ou « slices » en anglais) identiques travaillant en parallèle : chaque tranche opère sur 1 bit de donnée (architecture "bit-sliced"). La réalisation d'un noyau sur 32 bits revient donc à la réalisation et à l'optimisation d'une seule tranche qui sera répétée autant de fois que le nombre de bits composant le mot. Cette approche est en particulier tout à fait valable pour un additionneur qui est l'un des constituants du noyau. L'addition est également l'opération arithmétique la plus utilisée mais aussi le bloc limitant du noyau en termes de vitesse de traitement. L'architecture de l'additionneur est donc critique, il existe actuellement un certain nombre d'approches (en technologie CMOS) visant à optimiser celui-ci, on trouve des optimisations niveau circuit ou niveau logique (comme le "carry lookahead adder"). Un additionneur complet binaire FA est illustré en figure 3. A et B sont les bits à additionner. $C_{in}$ ("carry in") représente la retenue provenant d'une précédente somme (dans le cas d'une sommation sur n bits) et $C_{out}$ ($C_{in}$ du prochain additionneur) représente la retenue résultant du calcul ("carry out"). La table de vérité d'un tel additionneur FA est donnée dans le tableau 2 ci-dessous.

Tableau 2

| A | B | $C_{In}$ | S | $C_{out}$ |
|---|---|---|---|---|
| 0 | 0 | 0 | 0 | 0 |
| 0 | 0 | 1 | 1 | 0 |
| 0 | 1 | 0 | 1 | 0 |
| 0 | 1 | 1 | 0 | 1 |
| 1 | 0 | 0 | 1 | 0 |
| 1 | 0 | 1 | 0 | 1 |
| 1 | 1 | 0 | 0 | 1 |
| 1 | 1 | 1 | 1 | 1 |

Il existe plusieurs types d'architecture CMOS permettant la réalisation d'un additionneur binaire complet (Static Adder, Mirror Adder, Transmission-Gate-Based Adder), les objectifs étant essentiellement de minimiser le coût silicium et le temps de calcul de l'additionneur complet sur n bits. On peut réaliser un additionneur sur n bits en mettant en

cascade n additionneur $FA_0$ à $FA_{n-1}$, chaque additionneur étant un additionneur tel que représenté en figure 3. Un exemple d'un tel additionneur FAS complet sur n bits en série est représenté en figure 4. Dans cette configuration, la sortie de retenue $Cout_i$ de l'additionneur $FA_i$ est injectée dans l'entrée de retenue de l'additionneur $FA_{i+1}$. Cette structure montre que le temps de calcul $t_p^{adder}$ (ou le temps de propagation de l'additionneur complet) dépend essentiellement du temps de calcul de la retenue ainsi que de la propagation de celle-ci à travers la chaine (dépendant donc du nombre n de bit). Lorsque celui-ci augmente, il est alors nécessaire de passer à une approche d'optimisation logique-système pour diminuer le temps de propagation, passant d'une complexité linéaire comme ici ($t_p^{adder} \propto n$) à une complexité en racine de n ou logarithmique $\left( t_p^{adder} \propto \sqrt{n} \right)$ ou $\left( t_p^{adder} \propto \ln n \right)$, par exemple en mettant en oeuvre des additionneurs à anticipation de retenue.

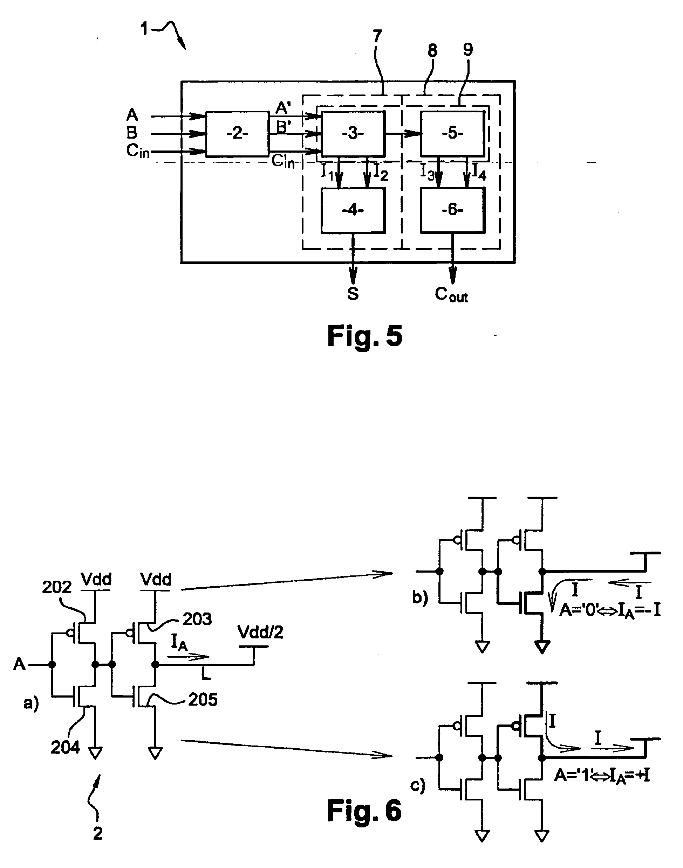

Selon un mode de réalisation particulièrement avantageux de la présente invention, il est possible de passer d'une technologie purement CMOS telle que présentée ci-dessus à une technologie combinant la technologie magnétique avec la technologie CMOS pour réaliser un circuit additionneur complet hybride, l'ensemble du calcul étant réalisé par la partie magnétique. La figure 5 illustre l'architecture d'un dispositif pour la réalisation d'une fonction logique du type additionneur **1** selon l'invention.

L'additionneur 1 a trois entrées logiques A, B $C_{in}$, A et B constituant les bits à additionner et $C_{in}$ constituant la retenue de l'additionneur précédent, et deux sorties logiques S et $C_{out}$ constituant respectivement la somme et la retenue telles que définies en référence à la table de vérité du tableau 2. Les entrées logiques A, B et $C_{in}$ correspondent à des niveaux de tension correspondant à la masse si la valeur logique est 0 et à une tension de polarisation d'une grille de transistor MOS si la valeur logique est 1.

L'additionneur 1 comporte :

- un premier bloc 2 d'interface d'entrée réalisé en technologie CMOS de génération de signaux de courant $I_A$, $I_B$ et $I_{Cin}$ alimentant trois lignes d'interconnexions dont le sens dépend de l'information logique appliquée en entrée;

- un deuxième bloc 7 de génération de la somme S ;

- un troisième bloc 8 de génération de la retenue $C_{out}$.

Le deuxième bloc 7 de génération de la somme S comporte :

- une partie magnétique 3 fonctionnant en mode différentiel et générant deux sorties d'informations magnétorésistives I1 et I2 ;

- une interface de sortie 4 réalisée en technologie CMOS permettant de convertir les informations magnétorésistives I1 et I2 en une tension compatible CMOS S.

De façon similaire, le troisième bloc 8 de génération de la retenue $C_{out}$ comporte :

- une partie magnétique 5 fonctionnant en mode différentiel et générant deux sorties d'informations magnétorésistives I3 et I4 ;

- une interface de sortie 6 réalisée en technologie CMOS permettant de convertir les informations magnétorésistives I3 et I4 en une tension compatible CMOS $C_{out}$.

L'additionneur hybride 1 se présente comme un système où les parties magnétiques 3 et 5 (ainsi que la topologie du système d'interconnexion comme nous le verrons par la suite) réalisent l'opération arithmétique et la partie CMOS (l'interface d'entrée 2 et les deux interfaces de sortie 4 et 6), fait office d'interface avec le monde extérieur.

Un mode de réalisation de réalisation de l'interface d'entrée 2 est représenté en figure 6 a). Cette interface 2 illustre la génération du courant $I_A$ à partir de l'information logique A ; deux autres circuits analogues peuvent être utilisés pour la génération de $I_B$ à partir de B et de $I_{Cin}$ à partir de $C_{in}$.

Conformément à l'invention, l'interface d'entrée 2 est entièrement réalisée en technologie CMOS. Cette interface 2 comporte quatre transistors 202-205 montés deux à deux en inverseurs CMOS connectés en série. En l'espèce, les transistors de la paire 202-203 sont du type PMOS, tandis que les transistors de la paire 204-205 sont du type NMOS (respectivement pour Positive Metal Oxyde semiconductor et Negative Metal Oxyde Semiconductor).

Les transistors PMOS 202 et 203 (symbolisés par un cercle rapporté sur leurs grilles) ont leurs sources communes connectées à une alimentation en tension Vdd et les transistors NMOS 204 et 205 ont leurs sources communes connectées à la masse.

Les transistors PMOS 202 et NMOS 204 ont leurs drains communs et les transistors PMOS 203 et NMOS 205 ont leurs grilles communes, le drain commun des transistors 202 et 204 étant relié à la grille commune des transistors 203 et 205.

**Les transistors PMOS 203 et NMOS 205 ont leurs drains communs reliés à une source d'alimentation égale à la moitié de la tension Vdd.**

Les transistors PMOS 202 et NMOS 204 ont leurs grilles communes et reçoivent l'information logique A sur cette grille. Conformément à la logique CMOS, cette information logique A est codifiée sous la forme d'un niveau de tension nulle si l'information binaire est 0 (de sorte que le transistor NMOS 204 est bloqué et le transistor PMOS 202 est passant) et sous la forme d'un niveau de tension positif si l'information binaire est 1 (de sorte que le transistor NMOS 204 est passant et le transistor PMOS 202 est bloqué).

Ainsi, si l'information logique à transmettre est « 'A'=0 », les transistors NMOS 204 et PMOS 203 sont bloqués, tandis que les transistors PMOS 202 et NMOS 205 sont passants et réciproquement si « 'A'=1 », les transistors NMOS 204 et PMOS 203 sont passants, tandis que les transistors PMOS 202 et NMOS 205 sont bloqués.

L désigne la ligne d'interconnexion dans laquelle circule le courant $I_A$ représentatif de l'information logique A. En considérant comme positif le courant I entrant dans la ligne L formant le système d'interconnexion (reliée aux drains et polarisée à Vdd/2) et comme négatif le courant sortant, on peut donc écrire en référence aux figures 6 b) et 6 c) l'équivalence suivante:

$$A='0' \Leftrightarrow I_A=-I \text{ (figure 6 c))}$$

$$A='1' \Leftrightarrow I_A=I. \text{ (figure 6 b))}.$$

Ainsi, le courant $I_A$ sera négatif dans le cas où l'information A est '0' et positif dans le cas où l'information A est '1'.

I désigne la valeur absolue du courant générant un champ local *H* au centre de la couche douce utilisée dans un dispositif selon l'invention et suffisamment intense pour permettre le passage de l'état parallèle à antiparallèle de celle-ci. Cette approche "mode courant" laisse également envisager la possibilité de travailler avec des tensions d'alimentation relativement basses (ce qui est intéressant dans l'optique actuelle du « downscaling »).

**Comme le courant d'écriture circule dans la ligne d'interconnexion L selon des directions opposées (aller ou retour), il est parfois qualifié de courant bidirectionnel.**

Ainsi, contrairement à la logique CMOS où l'information est codifiée sous la forme d'un niveau de tension, la logique de la partie magnétique utilise des courants de niveaux équivalents pour les deux valeurs binaires mais de sens opposés

Le bloc d'entrée 2 permet la conversion de l'information logique en mode tension (niveaux compatibles CMOS) en un courant dont le niveau est suffisant pour moduler l'état magnétique des empilements magnétorésistifs à travers les champs générés dans le circuit d'interconnexions.

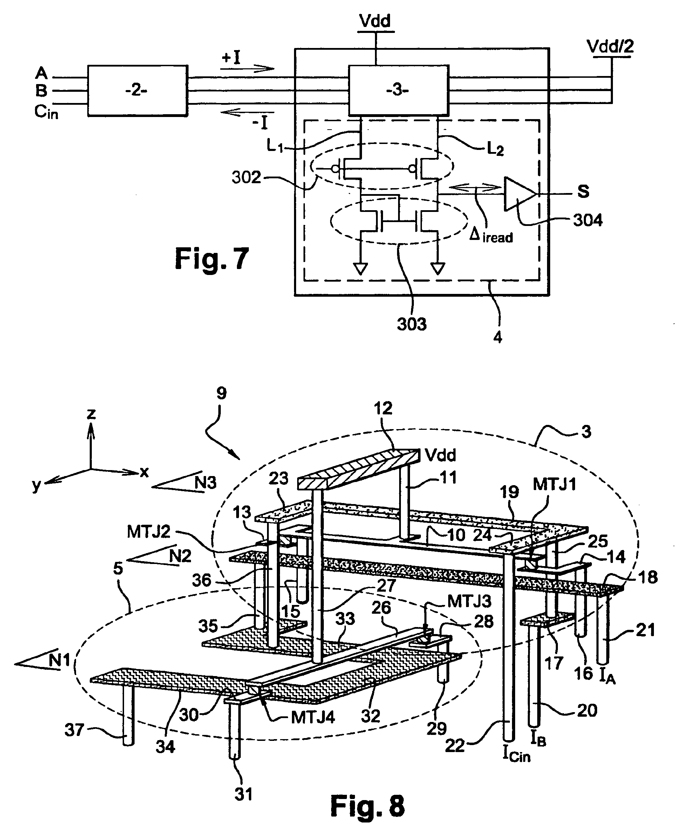

Les interfaces de sortie 4 et 6 sont réalisées en technologie CMOS. La figure 7 illustre un mode de réalisation de l'interface de sortie 4, l'interface de sortie 6 pouvant être réalisée de façon identique.

La figure 7 illustre donc l'interface de sortie 4 connectée électriquement par l'intermédiaire de deux lignes conductrices d'interconnexion L1 et L2 à la partie magnétique 3 (sur laquelle nous reviendrons par la suite) recevant des informations logiques codifiées sous la forme de courant +I ou -I de la part de l'interface d'entrée 2. La partie magnétique 3 comporte deux empilements magnétorésistifs polarisées à l'aide de la source de tension Vdd et générant respectivement un courant I1 et I2 dans les lignes conductrices L1 et L2, ces courants dépendant de la résistance électrique de chaque empilement (cette résistance dépendant elle-même de l'orientation du champ magnétique de la couche douce par rapport à l'orientation du champ magnétique de la couche dure de référence).

L'interface de sortie 7 comporte :

- un circuit de « clamp » 302 ;
- un circuit miroir de courant différentiateur 303 ;
- un élément tampon amplificateur 304.

Le circuit de « clamp » 302 (formant un limiteur de tension) est composé de deux transistors PMOS dont les grilles sont reliées, chaque transistor PMOS recevant respectivement sur sa source le courant I1 et le courant I2. Ces deux transistors PMOS de clamp permettent de limiter la tension de **polarisation $V_{bias}$ des empilements magnétorésistifs au moyen d'un réglage opéré en agissant sur la tension $V_{clamp}$ qui est appliquée sur les deux grilles.**

Comme le montre la figure 7, les courants issus des drains de chacun de ces transistors PMOS sont ensuite comparés au moyen du miroir de courant différentiateur 303. Pour former un tel miroir de courant différentiateur 303, on emploie deux transistors NMOS, dont les grilles sont portées au potentiel du drain de l'un d'entre eux de manière à générer le courant différentiel $\Delta i_{read}$ qui attaque le « buffer » amplificateur 304 ou tampon de sortie. Ce courant différentiel $\Delta i_{read}$ est représentatif de la différence de résistance $\Delta R$ entre les deux empilements magnétorésistifs.

Selon le sens du courant $\Delta i_{read}$, le miroir de courant différentiateur 303 charge ou décharge l'élément tampon amplificateur 304. Cet élément tampon a pour rôle de regénérer l'information numérique en la convertissant sous la forme d'une tension S compatible avec les niveaux logiques de composants CMOS.

L'interface de sortie permet de convertir les informations magnétorésistives I1 et I2 en une tension compatible CMOS. On aura ainsi par exemple :

- pour un $\Delta R>0$, 'S=1' (i.e. S a un niveau de tension correspondant à un 1 logique) ;
- pour un $\Delta R<0$, 'S=0' (i.e. S a un niveau de tension nul correspondant à un 0 logique).

La figure 8 représente une vue en trois dimensions selon un repère orthogonal xyz (x désignant l'axe des abscisses et y désignant l'axe des ordonnées de sorte que xy formant le plan horizontal et z désignant l'axe vertical) d'un mode de réalisation du circuit magnétique 9 du dispositif additionneur tel que représenté en figure 5 incluant la partie magnétique 3 de génération de somme et la partie magnétique 5 de la génération de retenue.

La partie magnétique 3 de génération de la somme comporte :

- un premier empilement magnétorésistif MTJ1 incluant une couche ferromagnétique dure et une couche ferromagnétique douce séparées par une couche intercalaire non ferromagnétique ;
- **un deuxième empilement magnétorésistif MTJ2 incluant une couche ferromagnétique dure et une couche ferromagnétique douce séparées par une couche intercalaire non ferromagnétique.**

On notera que les différentes couches des deux empilements MTJ1 et MTJ2 ne sont pas représentées par souci de clarté. La couche ferromagnétique douce est réalisée en un matériau magnétiquement doux tel que le Permalloy par exemple. Son aimantation répond ainsi facilement aux variations d'un champ magnétique extérieur qui y est appliqué. Cette couche est de préférence assez fine de sorte que son aimantation puisse tourner de façon importante sous l'effet de faibles flux magnétiques. La couche ferromagnétique dure présente une aimantation piégée. Par ailleurs, la couche de jonction intercalaire non ferromagnétique peut être réalisée en oxyde de magnésium (MgO) : un tel matériau permet d'obtenir une magnétorésistance TMR (Tunnel Magnetic Résistance) élevée et une résistance nominal faible. Pour mémoire, de manière connue, la résistance électrique d'un empilement de couches magnétiques est donnée en première approximation (tension de polarisation faible et température ambiante) par la relation :

$$R_{MTJ}= R_p.(1+TMR.(1-\cos\theta)/2)$$

où :

- $R_p$. est la résistance nominale de l'empilement magnétorésistif lorsque les aimantations des deux couches de l'empilement sont orientées dans le même sens ;
- TMR représente la magnétorésistance tunnel, c'est-à-dire la variation relative de résistance entre les états d'orientation extrêmes ;
- $\theta$ est l'angle formé entre les orientations des couches dures et douces.

Ainsi, lorsque $\theta$ vaut 0, l'empilement magnétorésistif se trouve dans un état parallèle où la résistance de l'empilement dans son état parallèle $R^p$ atteint son minimum et vaut $R_{MTJ}^{P} = R_p,$ tandis que lorsque $\theta=\pi$, l'empilement magnétorésistif est dans un état antiparallèle et la résistance électrique de l'empilement dans son état antiparallèle $R_{MTJ}^{ap}$ est maximale et vaut $R_{MTJ}^{ap} = R_p.(1+TMR).$

De préférence, les couches douces présentent une forme circulaire ou quasi-circulaire de façon à minimiser le courant d'écriture nécessaire à la modulation de leur orientation magnétique. De façon plus générale, les empilements utilisés ont la forme de plots de section circulaire ou quasicirculaire et non elliptique : contrairement aux mémoires, on cherche en effet ici à obtenir des empilements magnétorésistifs réalisés de manière à ce que la stabilité des axes faciles d'aimantation soit faible, de manière à ce qu'un champ faible magnétique suffise à les écarter de cette position, le but n'étant pas ici le maintien stable de l'information comme dans le cas d'une mémoire.

Les empilements MTJ1 et MTJ2 sont connectés sur leur partie supérieure par une électrode supérieure commune 10 de polarisation sensiblement dirigée suivant l'axe x. Cette électrode supérieure est reliée à un rail 12 d'alimentation en tension Vdd dirigé suivant l'axe y par un via conducteur vertical 11.

L'empilement MTJ1 est connecté sur sa partie inférieure par une électrode inférieure 14 reliée à un via conducteur vertical 16. Ce via conducteur 16 fournit le courant I1 formant l'entrée de l'interface de sortie 3 illustrée en figures 5 et 7.

L'empilement MTJ2 est connecté sur sa partie inférieure par une électrode inférieure 13 reliée à un via conducteur vertical 15. Ce via conducteur 15 fournit le courant 12 formant l'entrée de l'interface de sortie 3 illustrée en figures 5 et 7.

Comme nous l'avons déjà mentionné plus haut, le circuit magnétique 9 est réalisé par une pluralité de couches d'interconnexion comprenant une alternance de couches conductrices aussi appelées "niveaux de métallisation" pourvues de lignes conductrices métallisées s'étendant parallèlement à ladite couche et de couches isolantes (non représentées) traversées par des vias conducteurs permettant une connexion électrique entre deux niveaux de métallisation. Un niveau de métallisation comprend une pluralité de lignes conductrices entourées par des régions réalisées en matériau diélectrique.

Le circuit magnétique 9 est formé par trois niveaux de métallisation N1 à N3 qui vont permettre d'injecter les courants d'entrée $I_A$, $I_B$ et $I_{cin}$ transmis par l'interface d'entrée 2 telle qu'illustrée en figure 6. On notera que l'électrode supérieure 10 et les électrodes inférieures 13 et 14 des empilements magnétorésistifs MTJ1 et MTJ2 forment respectivement deux autres niveaux de métallisation non référencés sur la figure 8.

Nous allons décrire dans ce qui suit plus spécifiquement les trois niveaux de métallisation N1 à N3.

Chaque niveau de métallisation est formé par une ou plusieurs lignes de courant visant à orienter le champ magnétique des différentes couches douces en présence :

- Le niveau de métallisation N1 est représenté par des chevrons ;
- Le niveau de métallisation N2 situé au-dessus du niveau de métallisation N1 est représenté par des pointillés denses ;
- Le niveau de métallisation N3 situé au-dessus du niveau de métallisation N2 est illustré par des pointillés plus épars que pour le niveau N2.

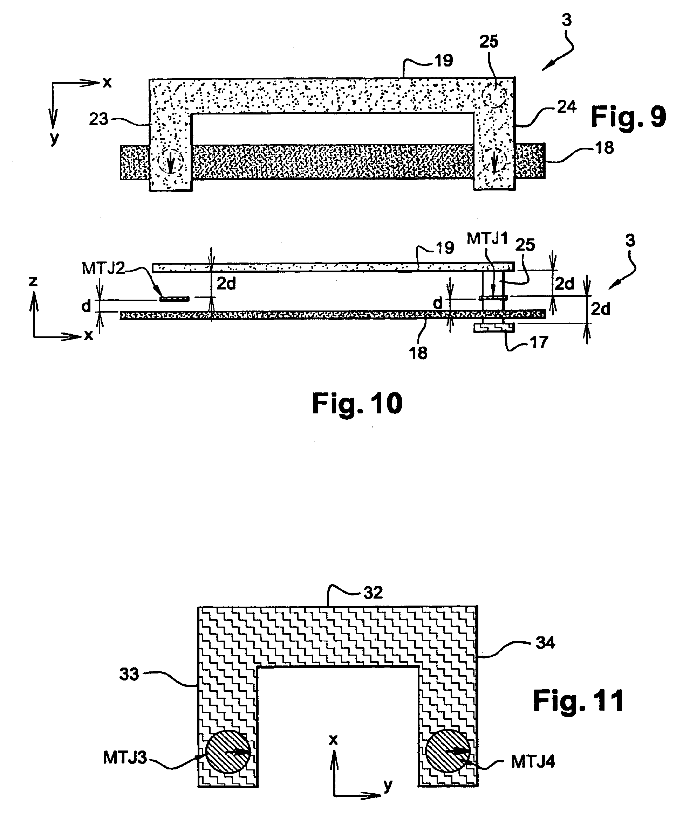

La partie magnétique 3 de génération de somme comporte trois lignes conductrices 17, 18, 19 appartenant respectivement aux niveaux de métallisation N1, N2 et N3. Les figures 9 et 10 représentent respectivement des vues de la partie magnétiques 3 de génération de somme dans le plan xy (vue de dessus) et xz (vue de face).

Les empilements MTJ1 et MTJ2 sont représentées en trait pointillé sur la figure 9 avec une flèche en trait plein symbolisant l'orientation magnétique de la couche dure de référence. Les aimantations des couches dures des deux empilements MTJ1 et MTJ2 sont positionnées dans le même sens (on notera d'ailleurs que l'on prendra la même orientation de la couche dure pour les deux autres couches dures des empilements MTJ3 et MTJ4 décrites plus tard dans le texte).

Trois via conducteurs verticaux 20, 21 et 22 d'accès à l'interface d'entrée CMOS telle que représentée aux figures 5 et 6 sont respectivement connectés électriquement aux lignes 17, 18 et 19. Le via vertical 20 permet d'injecter le courant $I_B$ valant +/-I (correspondant au niveau de tension B) dans la ligne 17. Le via vertical 21 permet d'injecter le courant $I_A$ valant +/-I (correspondant au niveau de tension A) dans la ligne 18. Le via vertical 22 permet d'injecter le courant $I_{Cin}$ valant +/-I (correspondant au niveau de tension $C_{in}$) dans la ligne 19.

**Par souci de clarté, les vias 20, 21 et 22 ainsi que les électrodes 10, 13 et 14 n'ont pas été représentés sur les figures 9 et 10.**

Il est important de préciser qu'à chaque instant (chaque pas de calcul) les empilements sont en équilibre sous champs : l'équilibre est maintenu tant que le courant est appliqué (c'est-à-dire pendant le fonctionnement du circuit) et est perdu dès que le courant n'est pas appliqué.

Nous entendrons par la suite par distance entre une ligne de courant et un empilement magnétorésistif, la distance séparant le centre de la couche douce et le point de la ligne le plus proche dudit centre de la couche douce.

La ligne de courant 18 (du niveau de métallisation N2 intermédiaire) que l'on appellera « ligne de polarisation magnétique » est une ligne dirigée suivant l'axe x et passant à la fois sous l'empilement magnétorésistif MTJ1 et sous l'empilement magnétorésistif MTJ2 à une distance d suivant l'axe z vertical. On notera que cette ligne de courant 18 pourrait également être au-dessus des empilements MTJ1 et MTJ2 à une même distance d et produire le même effet (avec un courant la traversant dans le sens opposé).

La ligne de courant 19 (du niveau de métallisation supérieure N3) est une ligne sensiblement en forme de U dont les deux branches parallèles 23 et 24 sont suivant l'axe y et sont situées au-dessus des empilements MTJ1 et MTJ2 à une distance double 2xd par rapport à la distance d séparant la ligne 18 des empilements MTJ1 et MTJ2.

La ligne de courant 17 (du niveau de métallisation inférieure N1) est une ligne suivant l'axe y et est située uniquement au-dessous de l'empilement MTJ1 à une distance double 2xd par rapport à la distance d séparant la ligne 18 de l'empilement MTJ1.

Par ailleurs, la ligne de courant 17 est reliée électriquement à la ligne de courant 19, au niveau de sa branche 24, grâce à un via d'interconnexion vertical 25 de sorte que les courants des lignes 17 et 19 sont sommés avant d'être acheminés sur la branche 23 de la ligne de courant 19 produisant ses effets sur l'empilement MTJ2.

En conséquence, pour le premier empilement magnétorésistif MTJ1, les lignes 19 et 17 approvisionnant les courants $I_{Cin}$ et $I_B$ sont de part et d'autre de l'empilement MTJ1 et à équidistance de celui-ci tandis que la ligne de courant 18 approvisionnant le courant $I_A$ est sous MTJ1 (ou au-dessus) à une distance moitié moins importante que les deux autres lignes 19 et 17. Ainsi, pour un courant I donné permettant une rotation de l'aimantation de la couche douce de l'empilement MTJ1 de l'état parallèle à l'état antiparallèle, le champ généré au centre de la couche douce par la ligne 18 est deux fois plus intense que celui généré par les lignes 19 et 17.

En ce qui concerne MTJ2, celle-ci est dans la même configuration par rapport la ligne 18 subissant une influence identique à MTJ1 ; en revanche, les courants des lignes 17 et 19 sont sommés (lois de Kirchhoff), cette somme étant acheminée sur la branche de la ligne 19 au dessus de l'empilement magnétorésistif MTJ2 à une distance double de celle associée à la ligne 18. On notera qu'on aurait également pu sommer les courants des lignes 17 et 19 et prendre une ligne 17 en U et une ligne 19 située uniquement au-dessus de l'empilement MTJ1. Dans ce cas, la somme des courants aurait été acheminée sur la branche de la ligne 17 au-dessous de l'empilement MTJ2 à une distance double de celle associée à la ligne 18.

Evaluons maintenant la réaction de la partie magnétique 3 de génération de somme aux différentes configurations possibles. On reprendra les hypothèses faites précédemment. Ainsi, en entrée, on considèrera que '0' $\Leftrightarrow$ -I et que '1' $\Leftrightarrow$ I. De même, en sortie, on aura :

$$\Delta R = R_{MTJ1} - R_{MTJ2} > 0 \Rightarrow S = '1' \text{ et,}$$
$$\Delta R = R_{MTJ1} - R_{MTJ2} < 0 \Rightarrow S = '0'.$$

On appellera $R^p_{MTJi}$ la résistance de l'empilement magnétorésistif MTJi dans son état parallèle ou sensiblement parallèle et $R^{ap}_{MTJi}$ la résistance de l'empilement MTJi dans son état antiparallèle ou sensiblement antiparallèle. Nous appellerons $R^{int}_{MTJi}$ la résistance de l'empilement magnétorésistif MTJi dans un état intermédiaire (θ compris entre 0 et π) entre $R^{ap}_{MTJi}$ et $R^p_{MTJi}$ de sorte que : $R^{ap}_{MTJi} > R^{int}_{MTJi} > R^p_{MTJi}$.

On peut ainsi écrire la table de génération des champs magnétiques vus par chacune des empilements MTJ1 et MTJ2 pour les différentes combinaisons du vecteur d'entrée A, B et $C_{in}$. Cette table est représentée dans le tableau 3 ci-dessous :

Tableau 3

| A | B | $C_{in}$ | $I_A$ | $I_B$ | $I_{CIN}$ | $H^x_{MTJ1}$ | $H^y_{MTJ1}$ | $H^x_{MTJ2}$ | $H^y_{MTJ2}$ |
|---|---|---|---|---|---|---|---|---|---|
| 0 | 0 | 0 | -I | -I | -I | $\dfrac{-H}{2} + \dfrac{H}{2} = 0$ | $+H$ | $\dfrac{-2H}{2} = -H$ | $+H$ |
| 0 | 0 | 1 | -I | -I | +I | $\dfrac{-2H}{2} = -H$ | $+H$ | $\dfrac{-H}{2} + \dfrac{H}{2} = 0$ | $+H$ |
| 0 | 1 | 0 | -I | +I | -I | $\dfrac{+2H}{2} = +H$ | $+H$ | $\dfrac{-H}{2} + \dfrac{H}{2} = 0$ | $+H$ |
| 0 | 1 | 1 | -I | +I | +I | $\dfrac{H}{2} - \dfrac{H}{2} = 0$ | $+H$ | $\dfrac{+2H}{2} = +H$ | $+H$ |
| 1 | 0 | 0 | +I | -I | -I | $\dfrac{-H}{2} + \dfrac{H}{2} = 0$ | $-H$ | $\dfrac{-2H}{2} = -H$ | $-H$ |

16

(suite)

| A | B | $C_{in}$ | $I_A$ | $I_B$ | $I_{CIN}$ | $H^x_{MTJ1}$ | $H^y_{MTJ1}$ | $H^x_{MTJ2}$ | $H^y_{MTJ2}$ |
|---|---|---|---|---|---|---|---|---|---|
| 1 | 0 | 1 | +I | -I | +I | $\dfrac{-2H}{2} = -H$ | -H | $\dfrac{-H}{2} + \dfrac{H}{2} = 0$ | -H |
| 1 | 1 | 0 | +I | +I | -I | $\dfrac{+2H}{2} = +H$ | -H | $\dfrac{-H}{2} + \dfrac{H}{2} = 0$ | -H |
| 1 | 1 | 1 | +I | +I | +I | $\dfrac{H}{2} - \dfrac{H}{2} = 0$ | -H | $\dfrac{+2H}{2} = +H$ | -H |

H représente l'intensité du champ généré au voisinage de la couche douce par un courant I circulant dans une ligne de courant située à une distance d du centre de la couche douce de l'empilement magnétorésistif MTJi. Dès lors, pour une ligne située à une distance 2xd, l'intensité du champ généré sera égale à H/2.

$H^x_{MTJi}$ et $H^y_{MTJi}$ représentent les composantes suivant les axes x et y du vecteur champ magnétique généré au voisinage de la couche douce de l'empilement MTJi.

On déduit des valeurs des composantes $H^x_{MTJi}$ et $H^y_{MTJi}$ pour les empilements magnétorésistifs MTJ1 et MTJ2 la table de vérité finale donnant en fonction des champs obtenues, les états résistifs de chacun des empilements magnétorésistifs $R_{MTJ1}$ et $R_{MTJ2}$, le signe de la variation de résistance sgn(ΔR) (où sgn() désigne la fonction signe) et la valeur binaire de sortie sous la forme d'une tension S générée par l'interface de sortie 4 représentée en figure 7. Cette table de vérité est représentée dans le tableau 4 ci-dessous. La détection par l'interface de sortie s'effectue sous champs : c'est la combinaison des champs magnétiques générés par chacune des entrées et via le réseau d'interconnexions spécifique pour chacune des deux parties magnétiques 3 et 5 (retenue, somme) qui va stabiliser les états magnétiques pendant le temps de lecture. Il est donc préférable d'utiliser des amplificateurs différentiels rapides permettant non seulement d'avoir un temps de propagation de l'additionneur faible (haute vitesse de calcul) mais également un temps de maintient (temps de « hold ») de l'information en entrée réduit, diminuant d'autant plus la consommation lors du fonctionnement. Opter pour une résistance nominale de l'empilement magnétorésistif relativement faible et une forte magnétorésistance tunnel (notamment en utilisant du MgO) est un avantage non négligeable sur la vitesse de lecture (de forts courants relatifs et absolus diminuent le temps de réponse de l'amplificateur).

Tableau 4

| $H^x_{MTJ1}$ | $H^y_{MTJ1}$ | $H^x_{MTJ2}$ | $H^y_{MTJ2}$ | $R_{MTJ1}$ | $R_{MTJ2}$ | sgn(ΔR) | S |
|---|---|---|---|---|---|---|---|
| 0 | +H | -H | +H | $R^P$ | $R^{INT}$ | ΔR<0 | 0 |
| -H | +H | 0 | +H | $R^{INT}$ | $R^P$ | ΔR>0 | 1 |
| +H | +H | 0 | +H | $R^{INT}$ | $R^P$ | ΔR>0 | 1 |
| 0 | +H | +H | +H | $R^P$ | $R^{INT}$ | ΔR<0 | 0 |
| 0 | -H | -H | -H | $R^{AP}$ | $R^{INT}$ | ΔR>0 | 1 |
| -H | -H | 0 | -H | $R^{INT}$ | $R^{AP}$ | ΔR<0 | 0 |
| +H | -H | 0 | -H | $R^{INT}$ | $R^{AP}$ | ΔR<0 | 0 |
| 0 | -H | +H | -H | $R^{AP}$ | $R^{INT}$ | ΔR>0 | 1 |

On pourra faire en sorte que les champs générés sur l'axe x (perpendiculaire aux aimantations de couches dures) soit plus intenses que les champs générés sur l'axe y pour permettre une bonne saturation des couches douces dans la direction considérée et pour maximiser ainsi la variation relative de résistance, soit : $H^x_{MTJi} > H^y_{MTJi}$

On obtient bien la somme S conformément à la table de vérité du "Binary Full Adder" FA donnée dans le tableau 2. On notera que des courants d'intensités identiques traversant des conducteurs de part et d'autre d'un empilement magnétorésistif vont générer des champs de sens contraires si ces courants sont dans le même sens et un champ maximum si ces courants sont de sens opposés : c'est le cas de l'empilement MTJ1. En ce qui concerne MTJ2, si les courants sommés sont de sens contraires, l'effet s'annule et le champ généré est nul ; s'ils sont dans le même sens, le champ est maximum.

La partie magnétique 5 de génération de retenue comporte :

- un troisième empilement magnétorésistif incluant une couche ferromagnétique dure et une couche ferromagnétique douce séparées par une couche intercalaire non ferromagnétique ;

- un quatrième empilement magnétorésistif MTJ4 formé par une couche ferromagnétique dure et une couche ferromagnétique douce séparées par une couche intercalaire non ferromagnétique.

Comme pour les empilements MTJ1 et MTJ2, les différentes couches des deux empilements magnétorésistifs MTJ3 et MTJ4 ne sont pas représentées par souci de clarté. La couche ferromagnétique douce est réalisée en un matériau magnétiquement doux tel que le Permalloy par exemple. Son aimantation répond ainsi facilement aux variations d'un champ magnétique extérieur qui y est appliqué. Cette couche est de préférence assez fine de sorte que son aimantation puisse tourner de façon importante sous l'effet de faibles flux magnétiques. La couche ferromagnétique dure présente une aimantation piégée. Par ailleurs, la couche de jonction intercalaire non ferromagnétique peut être réalisée en MgO.

De préférence, les couches douces présentent une forme circulaire ou quasi-circulaire de façon à minimiser le courant d'écriture nécessaire à la modulation de leur orientation magnétique.

Les aimantations des couches dures des deux empilements MTJ3 et MTJ4 sont positionnées dans le même sens que celles des empilements MTJ1 et MTJ2.

Les empilements MTJ3 et MTJ4 sont connectés sur leur partie supérieure par une électrode supérieure commune 26 de polarisation sensiblement dirigée suivant l'axe y. Cette électrode supérieure est reliée au rail 12 d'alimentation en tension Vdd par un via conducteur vertical 27.

L'empilement MTJ3 est connecté sur sa partie inférieure par une électrode inférieure 28 sensiblement dirigée suivant l'axe y et reliée à un via conducteur vertical 29. Ce via conducteur 29 fournit le courant I3 formant l'entrée de l'interface de sortie 5 représentée en figure 5.

L'empilement MTJ4 est connecté sur sa partie inférieure par une électrode inférieure 30 sensiblement dirigée suivant l'axe y et reliée à un via conducteur vertical 31. Ce via conducteur 31 fournit le courant 14 formant l'entrée de l'interface de sortie 5 représentée en figure 5.

La partie magnétique de génération de retenue 5 comporte en outre une ligne conductrice 32 appartenant au niveau de métallisation N1 (même niveau que la ligne conductrice 17). La figure 11 représente une vue de la partie magnétiques 5 de génération de retenue dans le plan xy (vue de dessus).

Les empilements MTJ3 et MTJ4 sont représentés sous la forme d'un cercle en trait plein hachuré sur la figure 11 avec une flèche en trait plein symbolisant l'orientation magnétique de la couche dure de référence.

La ligne de courant 32 est une ligne sensiblement en forme de U dont les deux branches parallèles 33 et 34 sont suivant l'axe x et sont situées respectivement au-dessous des empilements MTJ3 et MTJ4 à une distance d identique à la distance séparant la ligne de courant 18 des empilements MTJ1 et MTJ2. La forme en *U* de la ligne de courant 32 permet pour un même sens de courant de générer des champs magnétiques opposés dans chacune des empilements MTJ3 et MTJ4.

La partie magnétique de génération de retenue 5 comporte par ailleurs deux via conducteurs verticaux 35 et 36 reliant électriquement la ligne **de courant 32 respectivement à la ligne de courant 18 parcourue par le courant $I_A$ et à la portion 23 de la ligne de courant 19 parcourue par la somme des courants $I_B + I_{Cin}$.**

La somme des 3 courants $I_A + I_B + I_{Cin}$ circule ainsi dans la ligne de courant 32 dédiée à la retenue. Comme pour la partie magnétique 3 de génération de la somme, on peut ainsi écrire la table de génération des champs magnétiques vu par chacune des empilements MTJ3 et MTJ4 pour les différentes combinaisons du vecteur d'entrée A, B et $C_{in}$. Cette table est représentée dans le tableau 5 ci-dessous :

Tableau 5

| A | B | $C_{in}$ | $I_A$ | $I_B$ | $I_{CIN}$ | $\Sigma I$ | $H_{MTJ3}$ | $H_{MTJ4}$ |
|---|---|---|---|---|---|---|---|---|
| 0 | 0 | 0 | -I | -I | -I | -3I | -3H | +3H |
| 0 | 0 | 1 | -I | -I | +I | -I | -H | +H |

(suite)

| A | B | C_{in} | I_A | I_B | I_{CIN} | ΣI | H_{MTJ3} | H_{MTJ4} |
|---|---|---|---|---|---|---|---|---|
| 0 | 1 | 0 | -I | +I | -I | -I | -H | +H |
| 0 | 1 | 1 | -I | +1 | +I | +I | +H | -H |
| 1 | 0 | 0 | +1 | -I | -I | -I | -H | +H |
| 1 | 0 | 1 | +I | -I | +I | +I | +H | -H |
| 1 | 1 | 0 | +1 | +I | -I | +I | +H | -H |
| 1 | 1 | 1 | +1 | +1 | +I | +3I | +3H | -3H |

Contrairement au cas de la partie magnétique pour lequel on pouvait obtenir trois valeurs de résistance, les champs sont ici uniquement générés sur l'axe y relatif à l'aimantation de la couche dure de sorte que l'on a soit une résistance $R_{MTJi}^{p}$ de l'empilement magnétorésistif MTJi dans son état parallèle ou sensiblement parallèle soit une résistance $R_{MTJi}^{ap}$ de l'empilement magnétorésistif MTJi dans son état antiparallèle ou sensiblement antiparallèle. H représente l'intensité du champ généré au voisinage de la couche douce par un courant I circulant dans une ligne de courant situé à une distance d du centre de la couche douce de l'empilement MTJi.

On notera que la ligne de courant 32 de la partie magnétique de génération de retenue 5 comporte également un via conducteur vertical 37 reliée à la source de tension Vdd/2 qui permettra de générer les courants bidirectionnels tels qu'illustrés en figure 6.

On déduit des valeurs du champ pour les empilements MTJ3 et MTJ4 la table de vérité finale donnant en fonction des champs obtenues, les états résistifs de chacun des empilements $R_{MTJ3}$ et $R_{MTJ4}$, le signe de la variation de résistance sgn(ΔR) (où sgn() désigne la fonction signe et ΔR=$R_{MTJ3}$-$R_{MTJ4}$) et la valeur binaire de sortie sous la forme d'une tension $C_{out}$ générée par l'interface de sortie 6 représentée en figure 5. Cette table de vérité est représentée dans le tableau 6 ci-dessous :

Tableau 6

| H_{MTJ3} | H_{MTJ4} | R_{MTJ3} | R_{MTH} | sgn(ΔR) | C_{ont} |
|---|---|---|---|---|---|
| -3H | +3H | $R^P$ | $R^{AP}$ | ΔR<0 | 0 |
| -H | +H | $R^P$ | $R^{AP}$ | ΔR<0 | 0 |
| -H | +H | $R^P$ | $R^{AP}$ | ΔR<0 | 0 |
| +H | -H | $R^{AP}$ | $R^P$ | ΔR>0 | 1 |
| -H | +H | $R^P$ | $R^{AP}$ | ΔR<0 | 0 |
| +H | -H | $R^{AP}$ | $R^P$ | ΔR>0 | 1 |
| +H | -H | $R^{AP}$ | $R^P$ | ΔR>0 | 1 |
| +3H | -3H | $R^{AP}$ | $R^P$ | ΔR>0 | 1 |

On obtient bien une retenue $C_{out}$ conformément à la table de vérité du "Binary Full Adder" FA donnée dans le tableau 2. On notera que le circuit de génération 5 de la retenue se comporte comme un voteur majoritaire : en effet, la table de vérité de l'additionneur montre que si le nombre de 0 en entrée est supérieur au nombre de 1 alors la valeur de la retenue est 0 et inversement pour 1, cette opération étant plus difficile à réaliser en logique CMOS classique, le circuit complet nécessitant un nombre important de transistors. Ici, la somme de courants bidirectionnels d'intensités identiques et d'un système différentiel magnétique calibré à un seuil de retournement $\frac{H}{I}$ de permet de facilement réaliser cette opération. Rappelons qu'un voteur majoritaire est un composant comprenant un certain nombre d'entrées logiques et une sortie logique. Cette sortie vaut « 1 » si le nombre de « 1 » en entrée est supérieur au nombre de « 0 ». Notons que selon cette définition, un tel dispositif n'a de sens que si le nombre d'entrées est impair. Le tableau 7 montre la table de vérité d'un voteur majoritaire à 3 entrées.

Tableau 7

| a | b | c | Sv |
|---|---|---|---|
| 0 | 0 | 0 | 0 |
| 0 | 0 | 1 | 0 |
| 0 | 1 | 0 | 0 |
| 0 | 1 | 1 | 1 |
| 1 | 0 | 0 | 0 |
| 1 | 0 | 1 | 1 |
| 1 | 1 | 0 | 1 |
| 1 | 1 | 1 | 1 |

En comparant le tableau 2 et le tableau 7 et en prenant « a » égal à « A », « b » égal à « B », « c » égal à « $C_{in}$ » et « Sv » égal à « $C_{out}$ » on a bien la même table de vérité.

L'invention permet donc de combiner la technologie magnétique à base d'empilement magnétorésistif MTJ de première génération FIMS (pour « Field Induced Magnetic Switching », i.e. l'aimantation de la couche douce modifiée par application d'un champ magnétique généré par une ligne de courant au voisinage de l'empilement magnétorésistif) avec la technologie CMOS pour réaliser un additionneur "Binary Full Adder" hybride. Cette architecture est destinée aux applications de calculs intensifs nécessitant des performances relativement élevées, une consommation dynamique relativement basse et une densité d'intégration forte.

L'architecture de cet additionneur comprend donc *3* blocs, un premier bloc constitué de buffers CMOS dimensionnés en conséquence pour permettre la génération des courants bidirectionnels injectés dans le système d'interconnexions de la partie magnétique. La bidirectionnalité est assurée par une polarisation des lignes de routage à la moitié de la tension d'alimentation du circuit. Chacune des entrées (*A*, *B* et $C_{in}$) ayant des poids relatifs équivalents dans le calcul de l'addition, les buffers associés auront des tailles équivalentes. Les buffers pilotent donc 3 lignes d'interconnexions générant dans chacune d'elles un courant dont le sens dépend de l'information logique appliquée en entrée. Ces lignes traversent les deux structures magnétiques différentielles générant des champs locaux en fonction des courants mais également de la topologie du routage. C'est cette topologie qui va "fonctionnellement" différencier les parties magnétiques de génération de somme et de génération de la retenue de sortie (les réactions magnétiques des deux parties magnétiques étant différentes pour un même stimulus). L'utilisation d'une paire d'empilements magnétorésistifs fonctionnant en mode différentiel permet de bénéficier de la réjection en mode commun des amplificateurs de lecture et donc d'une bonne immunité au bruit. On obtient ainsi une variation de résistance $\Delta R$ "positive ou négative" en fonction de la direction du champ local appliqué et donc de la combinaison des courants injectés dans les lignes. Cette variation de résistance est générée sous la forme d'un courant différentiel par l'étage CMOS (amplificateur différentiel) et convertie sous la forme d'une tension afin d'obtenir l'information logique correspondante, la somme pour un bloc et la retenue pour l'autre, celle-ci pouvant être transmise au bloc suivant pour un calcul sur n bits. Nous verrons dans ce qui suit qu'il est également possible de transmettre cette information directement sous la forme d'un courant : on peut alors, dans une certaine mesure, s'abstenir de "réellement calculer" les retenues intermédiaires (c'est-à-dire de regénérer ces retenues sous forme de niveaux logiques grâce à la circuiterie CMOS).

Cette architecture présente un certain nombre d'avantages par rapport aux circuits CMOS équivalents, le premier étant la dissociation entre les circuits générant les stimuli d'entrées en mode courant (les données à sommer) et les circuits de génération des résultats permettant de globalement accroître les performances du système et de limiter la puissance dynamique consommée lors des calculs, ceci étant d'autant plus vrai avec les structures magnétiques différentielles utilisées nécessitant des courants relativement faibles. On peut considérer qu'il n'y a pas de contact entre l'émetteur des stimuli et la partie magnétique : dès lors, l'opération de calcul en elle-même ne consomme pratiquement pas de puissance.

Un deuxième avantage est la dissociation entre le calcul de la retenue et celui de la somme, les opérations étant ici totalement parallélisées. De plus, les structures magnétiques et CMOS sont totalement identiques, ce qui permet une optimisation, une simplification et une standardisation (standard cell) du process de réalisation d'un tel composant. Cette approche permet d'obtenir une densité importante pour la partie CMOS accentuée par le fait que l'additionneur peut utiliser moins de 20 transistors pour fonctionner (amplificateurs+buffers).

En outre, le développement des mémoires magnétiques MRAM assure la compatibilité du process magnétique avec le process standard CMOS (environnement digital). Dès lors, la partie magnétique peut donc être ajoutée en post-processing au-dessus de la partie CMOS (« Above-IC »). Dans cette approche, le calcul est effectué par la partie magnétique à l'aide de faibles variations (induites par la combinaison des champs locaux) des aimantations des empilements appariés autour des positions d'équilibres. Cette approche utilisée dans les logiques CMOS mode courant (CML) par exemple est bien adaptée à la réalisation des circuits digitaux rapides, la fonctionnalité étant fixée par la topologie du routage des interconnexions permettant une modulation en puissance et en direction des champs. La partie CMOS fait uniquement office d'interface assurant la compatibilité du circuit avec les composants "classiques" (regénération de l'information sous forme tension).

Enfin, un quatrième avantage est la possibilité de s'abstenir de calculer ou en d'autres termes, de regénérer la retenue de sortie sous forme d'une tension, la lecture étant le facteur limitant (en terme de vitesse) de cette architecture et de propager implicitement celle-ci sous la forme d'un courant, directement dans l'entrée correspondante ($C_{in}$) du deuxième additionneur. On peut ainsi réaliser un additionneur sur 4 bits ayant globalement la même vitesse que celui sur 2 bits. Lorsqu'on regarde les tableaux 5 et 6, on se rend compte que le signe de la somme des courants traversant la ligne de courant 32 de la retenue est totalement corrélé à l'information binaire de sortie $C_{out}$ (génération de la retenue par l'interface de sortie CMOS). Ce résultat est normal par construction, car lorsque l'on veut réaliser un additionneur n bits (il faut 32 additionneurs complets "Binary Full Adder" pour sommer 2 mots de 32 bits), il est nécessaire de propager la retenue d'étage en étage. Toutefois, les calculs de retenues intermédiaires n'ont pas d'utilité puisque seules la somme et la retenue finale sont importantes. Dès lors, on peut par exemple réaliser un additionneur 2 bits (somme de deux mots de 2 bits) en mettant en cascade deux additionneurs binaires, complets "Binary Full Adder" mais en s'affranchissant du calcul de la retenue intermédiaire, c'est-à-dire en réinjectant le courant somme associé au calcul de la retenue du premier étage directement dans la ligne d'entrée du deuxième (on supprime l'interface de sortie intermédiaire servant à regénérer la retenue intermédiaire). Cette approche permet d'avoir la même vitesse de calcul pour 1 bit que pour 2 bits. Cette approche peut être généralisée à un additionneur n bits. Le temps de propagation d'un additionneur n bits selon l'invention est en moyenne divisé par 2. De plus, dans le cas de l'additionneur 2 bits, ce dernier n'utilise plus que six empilements MTJ (les empilements associés au calcul de la retenue du premier étage étant inutiles), trois amplificateurs buffers (tels que l'amplificateur 304 de la figure 7) et cinq interfaces (trois interfaces d'entrée et deux interfaces de sortie). On diminue donc globalement la taille du système et on baisse la consommation moyenne puisque le courant du premier étage est utilisé dans le deuxième.

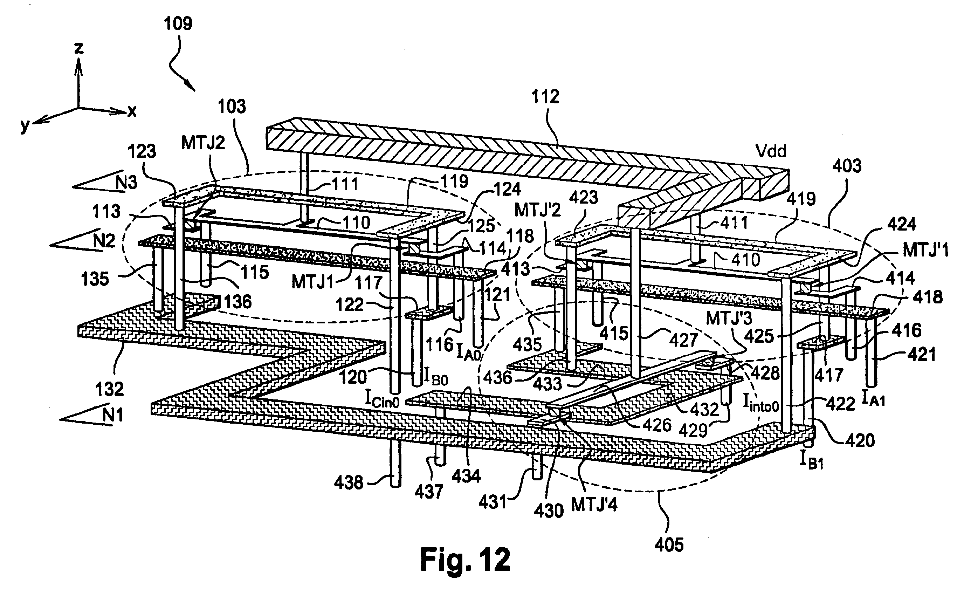

Ce quatrième avantage est illustré en référence à la figure 12 qui représente une vue en trois dimensions d'un additionneur 109 2 bits selon l'invention avec propagation de la retenue selon un repère orthogonal xyz. Cet additionneur 109 comporte une partie magnétique de génération 103 d'une première somme.

La partie magnétique 103 de génération de la première somme comporte :

- un premier empilement magnétorésistif MTJ1 ;

- un deuxième empilement magnétorésistif MTJ2.

On notera que les différents magnétorésistifs utilisés dans l'additionneur 109 sont identiques à ceux décrits précédemment en référence à l'additionneur 9 de la figure 8.

Les empilements magnétorésistifs MTJ1 et MTJ2 sont connectés sur leur partie supérieure par une électrode supérieure commune 110 de polarisation sensiblement dirigée suivant l'axe x. Cette électrode supérieure est reliée à un rail 112 d'alimentation en tension Vdd dirigé suivant l'axe y par un via conducteur vertical 111.

L'empilement MTJ1 est connecté sur sa partie inférieure par une électrode inférieure 114 reliée à un via conducteur vertical 116. Ce via conducteur 116 fournit le courant formant la première entrée d'une première interface de sortie CMOS telle que celle illustrée en figures 5 et 7.

L'empilement MTJ2 est connecté sur sa partie inférieure par une électrode inférieure 113 reliée à un via conducteur vertical 115. Ce via conducteur 115 fournit le courant formant la deuxième entrée de ladite première interface de sortie telle qu'illustrée en figures 5 et 7.

La première interface de sortie permet de générer le signal de sortie So tel qu'illustré en figure 4.

Le circuit magnétique 109 est formé par trois niveaux de métallisation N1 à N3 (identique à ceux décrits en référence à la figure 8) qui vont permettre d'injecter :

- les courants d'entrée $I_{A0}$ (correspondant au bit $A_0$ tel que représenté en figure 4), $I_{B0}$ (correspondant au bit $B_0$ à sommer avec $A_0$) et $I_{Cin}$ (correspondant à la retenue d'entrée $C_{in0}$ telle que représentée en figure 4) transmis par une première interface d'entrée CMOS telle qu'illustrée en figure 6.
- les courants d'entrée $I_{A1}$ (correspondant au bit $A_1$ tel que représenté en figure 4) et $I_{B1}$ (correspondant au bit $B_1$ à sommer avec $A_1$) transmis par une deuxième interface d'entrée CMOS telle qu'illustrée en figure 6 (on notera ici que l'interface d'entrée ne fournit pas le courant correspondant à la retenue $C_{out0}$ (ou $C_{in1}$) puisque cette dernière va être directement propagée sous forme de courant par le circuit magnétique).

La partie magnétique 103 de génération de la première somme comporte trois lignes conductrices 117, 118, 119 appartenant respectivement aux niveaux de métallisation N1, N2 et N3.

Trois via conducteurs verticaux 120, 121 et 122 d'accès à la première interface d'entrée CMOS sont respectivement connectés électriquement aux lignes 117, 118 et 119.

Le via vertical 120 permet d'injecter le courant $I_{B0}$ valant +/-I dans la ligne 117. Le via vertical 121 permet d'injecter le courant $I_{A0}$ valant +/-I dans la ligne 118. Le via vertical 122 permet d'injecter le courant $I_{Cin0}$ valant +/-I dans la ligne 119.

La ligne de courant 118 (du niveau de métallisation N2 intermédiaire) est une ligne dirigée suivant l'axe x et passant à la fois sous l'empilement MTJ1 et sous l'empilement MTJ2 à une distance d suivant l'axe z vertical. On notera que cette ligne de courant 118 pourrait également être au-dessus des empilements MTJ1 et MTJ2 à une même distance d et produire le même effet (avec un courant la traversant dans le sens opposé).

La ligne de courant 119 (du niveau de métallisation supérieure N3) est une ligne sensiblement en forme de U dont les deux branches parallèles 123 et 124 sont suivant l'axe y et sont situées au-dessus des empilements MTJ1 et MTJ2 à une distance double 2xd par rapport à la distance d séparant la ligne 18 des empilements MTJ1 et MTJ2.

La ligne de courant 117 (du niveau de métallisation inférieure N1) est une ligne suivant l'axe y et est située uniquement au-dessous de l'empilement MTJ1 à une distance double 2xd par rapport à la distance d séparant la ligne 118 de l'empilement MTJ1.

Par ailleurs, la ligne de courant 117 est reliée électriquement à la ligne de courant 119, au niveau de sa branche 124, grâce à un via d'interconnexion vertical 125 de sorte que les courants des lignes 117 et 119 sont sommés avant d'être acheminés sur la branche 123 de la ligne de courant 119 produisant ses effets sur l'empilement MTJ2.

L'additionneur 109 comporte une partie magnétique de génération 403 d'une seconde somme.

La partie magnétique 403 de génération d'une seconde somme est structurellement identique à la partie magnétique de génération de la première somme.

La partie magnétique 403 de génération de la seconde somme comporte :

- un troisième empilement magnétorésistif MTJ1' ;

- un quatrième empilement magnétorésistif MTJ2'.

Les empilements MTJ1' et MTJ2' sont connectés sur leur partie supérieure par une électrode supérieure commune 410 de polarisation sensiblement dirigée suivant l'axe x. Cette électrode supérieure est reliée au rail 112 d'alimentation en tension Vdd dirigé suivant l'axe y par un via conducteur vertical 411.

L'empilement MTJ1' est connecté sur sa partie inférieure par une électrode inférieure 414 reliée à un via conducteur vertical 416. Ce via conducteur 416 fournit le courant formant la première entrée d'une deuxième interface de sortie CMOS telle que celle illustrée en figures 5 et 7.

L'empilement MTJ2' est connecté sur sa partie inférieure par une électrode inférieure 413 reliée à un via conducteur vertical 415. Ce via conducteur 415 fournit le courant formant la deuxième entrée de ladite deuxième interface de sortie telle qu'illustrée en figures 5 et 7.

La deuxième interface de sortie permet de générer le signal de sortie $S_1$ tel qu'illustré en figure 4.

La partie magnétique 403 de génération de la seconde somme comporte trois lignes conductrices 417, 418, 419 appartenant respectivement aux niveaux de métallisation N1, N2 et N3.

Deux via conducteurs verticaux 420 et 421 d'accès à la deuxième interface d'entrée CMOS sont respectivement connectés électriquement aux lignes 417 et 418.

Le via vertical 420 permet d'injecter le courant $I_{B1}$ valant +/-I dans la ligne 417. Le via vertical 421 permet d'injecter le courant $I_{A1}$ valant +/-I dans la ligne 418.

La partie magnétique 403 de génération de la seconde somme comporte en outre un via vertical 422 permettant d'injecter un courant de retenue intermédiaire sur lequel nous reviendrons par la suite. Le via verticale 422 est reliée électriquement à la ligne de courant 419, au niveau de sa branche 424.

La ligne de courant 418 (du niveau de métallisation N2 intermédiaire) est une ligne dirigée suivant l'axe x et passant à la fois sous l'empilement MTJ1' et sous l'empilement MTJ2' à une distance d suivant l'axe z vertical.

La ligne de courant 419 (du niveau de métallisation supérieure N3) est une ligne sensiblement en forme de U dont les deux branches parallèles 423 et 424 sont suivant l'axe y et sont situées au-dessus des empilements MTJ1 et MTJ2 à une distance double 2xd par rapport à la distance d séparant la ligne 418 des empilements MTJ1 et MTJ2.

La ligne de courant 417 (du niveau de métallisation inférieure N1) est une ligne suivant l'axe y et est située uniquement au-dessous de l'empilement magnétorésistif MTJ1 à une distance double 2xd par rapport à la distance d séparant la ligne 418 de l'empilement MTJ1.

Par ailleurs, la ligne de courant 417 est reliée électriquement à la ligne de courant 419, au niveau de sa branche 424, grâce à un via d'interconnexion vertical 425 de sorte que les courants des lignes 417 et 419 sont sommés avant d'être acheminés sur la branche 423 de la ligne de courant 419 produisant ses effets sur l'empilement MTJ2'.

L'additionneur 109 comporte par ailleurs une ligne de courant 132 de propagation de retenue appartenant au niveau de métallisation N1 et deux via conducteurs verticaux 135 et 136 reliant électriquement la ligne de courant 132 respectivement à la ligne de courant 118 parcourue par le courant $I_{A0}$ et à la portion 123 de la ligne de courant 119 parcourue par la somme des courants $I_{B0}+I_{Cin0}$.

La somme des 3 courants $I_{A0}+I_{B0}+I_{Cin0}$ circule ainsi dans la ligne de courant 132 dédiée à la retenue propagée. Contrairement à la ligne 32 de l'additionneur 1 bit de la figure 8, cette ligne 132 ne sert pas à produire un champ magnétique sur deux empilements magnétorésistifs mais simplement à propager la retenue intermédiaire sous la forme d'un courant sans la regénérer sous la forme d'une tension compatible CMOS : on économise ici une interface de sortie ainsi que deux empilements.

La ligne de courant 132 est ensuite prolongée jusqu'au via conducteur vertical 422 pour fournir l'entrée en courant $I_{int0}$ de ce dernier.

L'additionneur 109 comporte une partie magnétique de génération de retenue finale 405.

Cette partie magnétique de génération de retenue finale 405 est structurellement identique à la partie magnétique de génération de retenue 5 telle que représentée en figure 8. Elle comporte :

- un cinquième empilement magnétorésistif MTJ3';

- un sixième empilement magnétorésistif MTJ4'.

Les empilements MTJ3' et MTJ4' sont connectés sur leur partie supérieure par une électrode supérieure commune 426 de polarisation sensiblement dirigée suivant l'axe y. Cette électrode supérieure est reliée au rail 112 d'alimentation en tension Vdd par un via conducteur vertical 427.

L'empilement magnétorésistif MTJ3' est connecté sur sa partie inférieure par une électrode inférieure 428 sensiblement dirigée suivant l'axe y et reliée à un via conducteur vertical 429. Ce via conducteur 429 fournit le courant formant l'entrée d'une troisième interface de sortie telle que représentée en figure 5.

L'empilement magnétorésistif MTJ4' est connecté sur sa partie inférieure par une électrode inférieure 430 sensiblement dirigée suivant l'axe y et reliée à un via conducteur vertical 431. Ce via conducteur 431 fournit le courant formant l'entrée de la troisième interface de sortie telle que représentée en figure 5.

La partie magnétique de génération de retenue finale 405 comporte une ligne conductrice 432 appartenant au niveau de métallisation N1 (même niveau que la ligne conductrice 417).

La ligne de courant 432 est une ligne sensiblement en forme de U dont les deux branches parallèles 433 et 434 sont suivant l'axe x et sont situées respectivement au-dessous des empilements MTJ3' et MTJ4' à une distance d identique à la distance séparant la ligne de courant 418 des empilements MTJ1' et MTJ2'. La forme en U de la ligne de courant 432 permet pour un même sens de courant de générer des champs magnétiques opposés dans chacun des empilements MTJ3' et MTJ4'.

On notera que la ligne de courant 432 de la partie magnétique de génération de retenue 405 comporte également un via conducteur vertical 437 reliée à la source de tension Vdd/2 qui permettra de générer les courants bidirectionnels tels qu'illustrés en figure 6.

La partie magnétique de génération de retenue finale 405 comporte par ailleurs deux via conducteurs verticaux 435 et 436 reliant électriquement par ailleurs deux via conducteurs verticaux 435 et 436 reliant électriquement la ligne de courant 432 respectivement à la ligne de courant 418 parcourue par le courant $I_{A1}$ et à la portion 423 de la ligne de courant 419 parcourue par la somme des courants $I_{B1}+I_{int0}$.

La somme des 3 courants $I_{A1}+I_{B1}+I_{int0}$ circule ainsi dans la ligne de courant 432 dédiée à la retenue finale.

L'additionneur 109 comporte par ailleurs un via vertical 438 connecté électriquement à la ligne de courant de propagation de la retenue 132 : nous reviendrons dans ce qui suit sur l'utilisation de ce via 438.

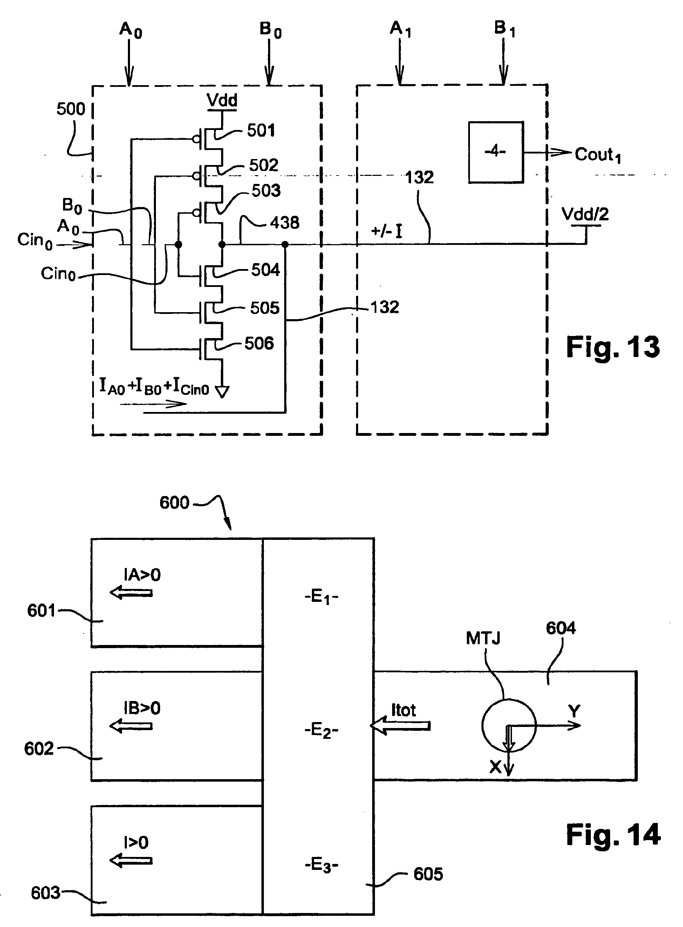

L'approche proposée ci-dessus suppose toutefois de limiter le courant $I_{int0}$ à injecter dans le via conducteur 422 à I en valeur absolue ; or cette valeur est dépassée pour les vecteurs ($A_0$ $B_0$ $Cin_0$) valant 000 et 111. Lorsque le vecteur d'entrée est 000, la somme des courants injecté est -3xI et lorsque le vecteur d'entrée est 111, la somme des courants injecté est 3xI. Pour palier à ce problème, on peut utiliser le circuit limiteur CMOS 500 tel qu'illustré en figure 13 pour réguler le courant à partir du vecteur d'entrée, action qui ne pénalise pas les performances en regard des temps de réponse des amplificateurs sur les parties magnétiques qui peuvent être relativement long.

Le circuit limiteur CMOS 500 comporte :

- trois transistors PMOS 501, 502 et 503 montés en série, la source du premier transistor PMOS 501 étant connectée à l'alimentation Vdd ;
- trois transistors NMOS 504, 505 et 506 montés en série, la source du troisième transistor NMOS 506 étant reliée à la masse.

Les six transistors PMOS et NMOS sont montés en série de sorte que le drain du premier transistor NMOS 504 est connecté au drain du troisième transistor PMOS 503.

Le premier transistor PMOS 501 et le troisième transistor NMOS 506 ont leur grille commune sur laquelle est injecté le signal $A_0$.

Le deuxième transistor PMOS 502 et le deuxième transistor NMOS 505 ont leur grille commune sur laquelle est injecté le signal $B_0$.

Le troisième transistor PMOS 503 et le premier transistor NMOS 504 ont leur grille commune sur laquelle est injecté le signal $C_{in0}$.

Le drain commun du premier transistor NMOS 504 et du troisième transistor PMOS 503 est connecté à la ligne de courant 132 de propagation de la retenue par le via conducteur vertical 438 (également représenté sur la figure 12).

Comme déjà évoqué plus haut, chaque ligne de courant est connectée à la source de tension Vdd/2 (par le via conducteur 437) de façon à pouvoir transmettre un courant bidirectionnel.

Lorsque le vecteur d'entrée est 000, la somme des courants injecté dans la ligne 132 est -3xI ; le limiteur 500 injecte alors un courant 2xI dans le via 438 (activation des transistors PMOS 501 à 503) pour limiter le courant à -I, conservant dans le même temps le signe. De la même manière, si le vecteur est à 111, la somme des courants injecté est +3xI ; le limiteur injecte -2xI dans le via 438 (activation des NMOS 504 à 506) pour limiter le courant à +I. On a donc bien toujours un courant égal à +/-I dans la branche de la ligne de courant 132 située après le limiteur 500. En regard de l'architecture du limiteur, les autres combinaisons du vecteur d'entrée n'ont pas d'effets sur le courant.

Bien entendu, l'invention n'est pas limitée au mode de réalisation qui vient d'être décrit.

Notamment, l'invention a été plus particulièrement décrite dans le cas d'un additionneur 1 bit ou 2 bits mais elle trouve d'autres applications dans la génération d'autres types de fonctions logiques.

A titre d'exemple, nous allons présenter dans ce qui suit un dispositif pour la réalisation d'une porte « et » logique selon l'invention à partir d'un empilement magnétorésistif à écriture par champ. Une porte « et » à deux entrées donne la valeur « 1 » logique en sortie si et seulement si toutes ses entrées sont à « 1 ». Ceci se traduit par la table de vérité donnée dans le tableau 8 ci-dessous.

Tableau 8

| A B | 0 | 1 |
|---|---|---|
| 0 | 0 | 0 |
| 1 | 0 | 1 |

Comme précédemment, les entrées A et B sont codées en courant de sorte que :

A='0' $\Leftrightarrow I_A$=-I

A='1' $\Leftrightarrow I_A$=I

B='0' $\Leftrightarrow I_B$=-I

B='1' $\Leftrightarrow I_B$=I

Ainsi, les courants $I_A$ et $I_B$ seront négatifs dans le cas où l'information est '0' et positifs dans le cas où l'information est '1'.

La figures 14 a) et b) représentent de manière schématique un dispositif 600 pour la réalisation d'une porte « et » logique respectivement en vue de dessus (plan xy) et en coupe latérale (suivant le plan zy).

Le dispositif 600 comporte :

- un empilement magnétorésistif incluant une couche ferromagnétique dure et une couche ferromagnétique douce séparées par une couche intercalaire non ferromagnétique (les caractéristiques de cet empilement sont identiques à celles décrites précédemment en référence aux autres modes de réalisation de l'invention).

- une première ligne de courant 601 dirigée suivant l'axe y et recevant le courant $I_A$ ;

- une deuxième ligne de courant 602 dirigée suivant l'axe y et recevant le courant $I_B$ ;

- une troisième ligne de courant dirigée suivant l'axe y 603 ;

- une quatrième ligne de courant 604.

La valeur absolue du courant est toujours la même (égale à I). L'état de l'empilement magnétorésistif MTJ représente la sortie de la porte « et »: l'état parallèle de l'empilement magnétorésistif représente un « 1 », l'état antiparallèle un « 0 ». Les flèches de courant représentent le sens dans lequel le courant est compté positivement. Avec les conventions utilisées, un courant positif génère un champ positif suivant l'axe x.

La quatrième ligne de courant 604 est une ligne dirigée suivant l'axe y et passant au-dessus de l'empilement MTJ à une distance d suivant l'axe z vertical.

Dans ce dispositif 600, la ligne 603 est une ligne supplémentaire nécessaire pour briser la symétrie du dispositif : en effet, si l'on n'a que les lignes correspondant aux entrées A et B (601 et 602) et que l'on inverse les valeurs des entrées, l'état magnétique sera forcément opposé. On ne pourra donc pas avoir la même configuration de sortie pour les combinaisons « 01 » et « 10 » des entrées comme c'est le cas pour une porte « et ». En utilisant cette ligne 603 de courant supplémentaire dont la valeur du courant la traversant est constante, on amène une dissymétrie sous forme d'un décalage de champ. Cette ligne 603 est toujours parcourue par un courant négatif de valeur -I.

Les trois lignes de courant 601, 602 et 603 sont interconnectées à la quatrième ligne de courant 604 via une ligne de courant 605 dirigée suivant x de façon à former trois points d'entrée $E_1$, $E_2$ et $E_3$ de courant dans la quatrième ligne de courant 604 de sorte que les courants circulant dans les trois lignes de courant 601, 602 et 603 s'additionnent pour circuler dans la quatrième ligne de courant 604 ; selon les conventions prises ici, le courant $I_{tot}$ circulant dans ladite quatrième ligne de courant 604 est tel que :

$$I_{tot} = I_A + I_B + I.$$

L'intensité du champ magnétique généré dépend directement de l'intensité du courant qui traverse la ligne. Dès lors, on additionnant les courants d'entrée sur les points d'entrée $E_1$, $E_2$ et $E_3$ arrivant sur la quatrième ligne de courant 604, on modifie la valeur de l'intensité du champ magnétique H généré par la quatrième ligne 604. L'état magnétique de l'empilement magnétorésistif et donc la valeur de sortie en fonction des valeurs des entrées sont données sur le tableau 9 ci-dessous. La fonction « et » est bien réalisée.

Tableau 9

| A | B | $I_a$ | $I_b$ | I | $I_{tot}$ | H | Etat | Sortie |
|---|---|---|---|---|---|---|---|---|
| 0 | 0 | -I | -I | -I | -3I | -3H | AP | 0 |
| 0 | 1 | -I | I | -I | -I | -H | AP | 0 |
| 1 | 0 | I | -I | -I | -I | -H | AP | 0 |
| 1 | 1 | I | I | -I | I | H | P | 1 |

Nous avons mentionné dans le tableau 9 deux états stables de la résistance électrique de l'empilement MTJ : soit un état parallèle P soit un état antiparallèle pour la résistance électrique de l'empilement MTJ. Il n'est toutefois pas nécessaire d'avoir une jonction stable. Le choix d'une jonction instable peut même se révéler avantageux puisque celle-ci réagira plus facilement au champ magnétique, ce qui améliorera la vitesse et la consommation. Rappelons que la résistance électrique de l'empilement MTJ est donnée en première approximation (tension de polarisation faible et température ambiante) par la relation :

$$R_{MTJ} = R_p.(1 + TMR.(1 - \cos\theta)/2)$$

où :

- $R_p$. est la résistance nominale de l'empilement magnétorésistif lorsque les aimantations des deux couches de l'empilement sont orientées dans le même sens ;
- TMR représente la magnétorésistance tunnel, c'est-à-dire la variation relative de résistance entre les états d'orientation extrêmes ;
- $\theta$ est l'angle formé entre les orientations des couches dures et douces.

Ainsi, lorsque θ vaut 0, l'empilement magnétorésistif se trouve dans un état parallèle où la résistance de l'empilement dans son état parallèle $R^P$ atteint son minimum et vaut $R^P_{MTJ} = \mathsf{R_p,}$ tandis que lorsque θ=π, l'empilement magnétorésistif est dans un état antiparallèle et la résistance électrique de l'empilement dans son état antiparallèle $R^{ap}_{MTJ}$ est maximale et vaut $R^{ap}_{MTJ} = \mathsf{R_p.(1+TMR).}$

Dans une approche de type mémoire (donc différente de l'invention), l'information est stockée de manière non-volatile. Il est donc nécessaire que la jonction ait une stabilité importante. Cette stabilité peut être obtenue de plusieurs manières, en augmentant par exemple l'anisotropie de forme. Dans une utilisation classique de type mémoire, l'empilement est donc ovale avec un grand facteur de forme. L'axe de facile aimantation est alors dirigé suivant le grand axe de la jonction. Dans cette approche, le champ appliqué de manière à écarter l'aimantation de sa position d'équilibre suffisamment pour que lorsque le champ n'est plus appliqué, l'aimantation rejoigne sa deuxième position stable et la conserve (fonctionnement bistable). L'information est donc conservée en dehors de toute sollicitation extérieure, d'où le caractère non-volatile. On parlera donc dans ce cas de « basculement » de l'aimantation. Dans ce cas, l'aimantation de la couche dure est alignée avec cet axe de facile aimantation de manière à basculer entre des états Parallèle et AntiParallèle pour bénéficier d'une TMR maximale.

Dans l'approche concernée par la présente invention, l'effet mémoire n'est pas recherché : l'information doit juste être maintenue pendant la calcul, c'est-à-dire lorsque le champ est appliqué. La stabilité est donc ici assurée par le champ magnétique appliqué pendant le fonctionnement. Il n'est donc pas nécessaire d'avoir une jonction stable. Le choix d'une jonction instable va même se révéler avantageux puisque celle-ci réagira plus facilement au champ magnétique, ce qui améliorera la vitesse et la consommation.

Afin de réduire la stabilité de la jonction, on pourra utiliser des couches de l'empilement rondes, ou presque rondes (avec un facteur de forme peu important). La couche douce conserve un axe de facile aimantation du à l'anisotropie magnétocristalline. L'application d'un champ magnétique ne va pas dans ce cas faire basculer l'aimantation de la couche douce entre deux états stables, mais écarter l'aimantation de sa position stable d'un angle θ, positif ou négatif selon l'information codée ('0' ou '1'). Afin de différentier ce fonctionnement du fonctionnement mémoire précédemment décrit, nous parlerons de « modulation » de l'aimantation plutôt que de « basculement ». Dans ce cas, l'aimantation de la couche dure doit être perpendiculaire à l'axe de facile aimantation de sorte que l'aimantation de la couche douce approche de l'état Parallèle ou AntiParallèle .

Selon cette approche, c'est donc le signe de l'angle qui représenera la valeur binaire '0' ou '1'. Quelle que soit la position stable initiale, le fonctionnement reste parfaitement symétrique. Le choix de la valeur absolue de θ va alors permettre de choisir entre vitesse et consommation : un angle θ petit va nécessiter un champ magnétique moindre, mais le signal sera moins important ce qui ralentira le circuit de lecture CMOS. Un angle plus important augmentera la vitesse de lecture.

Selon l'invention, c'est la l'interconnexion des lignes de courant d'écriture qui forme la fonction logique. Bien entendu, on peut avantageusement utiliser à la fois l'interconnexion des lignes d'écriture et des distances différentes entre les lignes d'écriture et l'empilement magnétorésistif pour créer des fonctions logiques plus complexes telles qu'illustrées dans le cas des additionneurs représentés en figures 8 et 12. La somme des courants ainsi que les distances entre les lignes sont déterminées à partir de la fonction logique à réaliser.

Cette approche permet d'éviter l'utilisation de parties CMOS intermédiaires au composant, celle-ci n'étant pas décomposée en blocs élémentaires de type « et », « ou » ou « complément ».

Les parties CMOS sont seulement utilisées pour réaliser les interfaces d'entrée et de sortie de la fonction. Ceci permet de s'affranchir des temps de réponse inhérents à une technologie CMOS et de profiter pleinement des qualités des composants magnétiques en termes de vitesse et de consommation.

**Revendications**

1. Dispositif (9) pour la réalisation d'une « fonction logique» comprenant une structure magnétique comportant :

    - au moins un premier empilement magnétorésistif (MTJ3) incluant une première couche ferromagnétique et une deuxième couche ferromagnétique séparées par une couche intercalaire non ferromagnétique, la deuxième couche étant une couche ferromagnétique douce tandis que la première couche est une couche ferromagnétique dure piégée dans un état magnétique fixe servant de référence,
    - au moins une première ligne (32) de courant située au voisinage dudit premier empilement magnétorésistif (MTJ3) et engendrant au voisinage dudit premier empilement (MTJ3) un champ magnétique lorsqu'elle est traversée par un courant électrique,

ladite première ligne (32) comportant, pour ledit au moins un empilement, au moins deux points d'entrées de courant de sorte que deux courants s'additionnent dans ladite première ligne (32), la somme desdits deux courants étant déterminée par ladite fonction logique,

ledit dispositif (9) étant **caractérisé en ce que** ladite première ligne (32) est connectée à au moins une autre ligne (19, 18) de courant appartenant à un niveau de métallisation différent du niveau de métallisation de ladite première ligne (32), les deux lignes étant reliées par une ligne conductrice d'interconnexion (36, 35) et le point de connexion entre ladite ligne d'interconnexion (36, 35) et ladite première ligne (32) formant l'un desdits deux points d'entrée de courant.

2. Dispositif (9) selon la revendication précédente **caractérisé en ce que** lesdits au moins deux points d'entrées de courant injectent respectivement un courant $I_1$ et $I_2$ dans ladite première ligne de sorte que l'intensité H' du champ généré par ladite première ligne au voisinage de ladite couche douce est telle que $\dfrac{H'}{H} = \dfrac{I_1 + I_2}{I}$ où H est l'intensité du champ magnétique généré par ladite première ligne de courant lorsque celle-ci est parcourue par un courant I.

3. Dispositif (9) selon l'une des revendications précédentes **caractérisé en ce qu'**il comporte :

- au moins un deuxième empilement magnétorésistif (MTJ1) qui peut être soit confondu avec ledit premier empilement soit différent dudit premier empilement, ledit deuxième empilement incluant une première couche ferromagnétique et une deuxième couche ferromagnétique séparées par une couche intercalaire non ferromagnétique,
- au moins deux lignes de courant (18, 19) appartenant respectivement à un premier (N3) et un deuxième (N2) niveau de métallisation, chacune desdites deux lignes engendrant un champ magnétique au voisinage dudit deuxième empilement lorsqu'elles sont traversées par un courant électrique,

lesdites deux lignes (19, 18) étant disposées à des distances différentes de ladite deuxième couche ferromagnétique dudit deuxième empilement (MTJ1).

4. Dispositif (9) selon la revendication précédente **caractérisé en ce que** lesdites deux lignes (18, 19) sont situées de part et d'autre dudit deuxième empilement magnétorésistif (MTJ1).

5. Dispositif (9) selon l'une des revendications 3 ou 4 **caractérisé en ce que** l'une desdites deux lignes est située à une distance d1 au dessus de ladite deuxième couche et l'autre desdites deux lignes est située à une distance d2 au dessous de ladite deuxième couche, de sorte que, pour deux courants de même intensité circulant respectivement dans l'une et l'autre desdites deux lignes, les intensités N1 et H2 des champs générés respectivement par la ligne située à la distance d1 et par la ligne située à la distance d2 au voisinage de ladite deuxième couche soient telles que : $\dfrac{H_1}{H_2} = \dfrac{d_2}{d_1}$ .

6. Dispositif (9) selon l'une des revendications précédentes **caractérisé en ce qu'**il comporte :

- au moins un empilement magnétorésistif (MTJ1) incluant une première couche ferromagnétique et une deuxième couche ferromagnétique séparées par une couche intercalaire non ferromagnétique,,
- au moins deux lignes de courant (19, 17) appartenant respectivement à un premier (N3) et un deuxième (N1) niveau de métallisation, chacune desdites deux lignes engendrant un champ magnétique au voisinage dudit au moins un empilement lorsqu'elles sont traversées par un courant électrique,

lesdites deux lignes (19, 17) étant disposées à égale distance de part et d'autre de ladite deuxième couche ferromagnétique.

7. Dispositif (9) selon l'une des revendications précédentes **caractérisé en ce que** la ou les premières couches ferromagnétiques sont des couches ferromagnétiques dures piégées dans un état magnétique fixe qui sert de référence et la ou les deuxièmes couches ferromagnétiques sont des couches ferromagnétiques douces.

**8.** Dispositif selon la revendication 7 **caractérisé en ce que** la couche dure de chacun des empilements magnétorésistifs est piégée dans un état magnétique perpendiculaire à un axe de facile aimantation servant de référence pour la couche douce du même empilement, cette couche douce de l'empilement magnétorésistif présentant une orientation magnétique modulable par le courant issue de la ou des ligne(s) de courant située(s) au voisinage de l'empilement magnétorésistif de manière à induire une modification de la résistance transversale de l'empilement suffisante pour déclencher un signal électrique, cette modulation de l'orientation magnétique de la couche douce de l'empilement étant suffisamment faible pour que cette orientation ne bascule pas entre deux positions stables mais fluctue autour d'une position stable.

**9.** Dispositif selon l'une des revendications précédentes **caractérisé en ce qu'**il comporte une interface d'entrée (2) comportant :

- au moins une entrée recevant une information logique codifiée sous la forme d'un niveau de tension représentant un '0' ou un '1' logique ;
- au moins une sortie reliée à une ligne conductrice d'interconnexion ;
- des moyens électroniques pour générer dans ladite ligne conductrice d'interconnexion un courant dont le sens est représentatif de l'information logique, la valeur absolue de l'intensité dudit courant étant identique dans un sens ou dans l'autre dudit courant.

**10.** Dispositif selon l'une des revendications 1 à 9 **caractérisé en ce qu'**il comporte :

- un deuxième empilement magnétorésistif incluant une première couche ferromagnétique et une deuxième couche ferromagnétique séparées par une couche intercalaire non ferromagnétique ;
- une interface de sortie (4) reliée électriquement aux dits premier et deuxième empilements magnétorésistifs, ladite interface comportant :

  ○ une première entrée reliée à une ligne conductrice d'interconnexion reliant électriquement ladite première entrée au dit premier empilement magnétorésistif ;
  ○ une deuxième entrée reliée à une ligne conductrice d'interconnexion reliant électriquement ladite deuxième entrée au dit deuxième empilement magnétorésistif ;
  ○ des moyens pour générer un courant différentiel ($\Delta i_{read}$) entre le courant circulant dans ledit premier empilement et le courant circulant dans ledit deuxième empilement lorsque ceux-ci sont soumis à une tension de polarisation, ledit courant différentiel étant représentatif d'une information logique ;
  ○ des moyens pour générer une tension (S) représentative de ladite information logique en fonction dudit courant différentiel.

**11.** Additionneur (9) incorporant un dispositif selon l'une des revendications 1 à 10, ledit additionneur (9) comprenant :

- une interface d'entrée (2) de signaux de courant $I_A$, $I_B$ et $I_{Cin}$ alimentant trois lignes d'interconnexions,
- une structure magnétique comprenant :

  ○ une partie magnétique (3) de génération de ladite somme,
  ○ une partie magnétique (5) de génération de ladite retenue, ladite partie magnétique (5) de génération de ladite retenue comportant :

- un premier empilement magnétorésistif (MTJ3) incluant une couche ferromagnétique dure et une couche ferromagnétique douce séparées par une couche intercalaire non ferromagnétique, la couche ferromagnétique dure étant piégée dans un état magnétique fixe qui sert de référence,
- un deuxième empilement magnétorésistif (MTJ4) incluant une couche ferromagnétique dure et une couche ferromagnétique douce séparées par une couche intercalaire non ferromagnétique, la couche ferromagnétique dure étant piégée dans un état magnétique fixe qui sert de référence,
- une première ligne de courant (32) engendrant un champ magnétique au voisinage desdits premier et deuxième empilement (MTJ3, MTJ4) et étant située à une distance d suivant l'axe vertical des couches douces de chacun desdits premier et troisième empilement (MTJ3, MTJ4),
- un premier et un deuxième via conducteur vertical (35, 36) reliant électriquement ladite première ligne de courant (32) respectivement à une deuxième ligne de courant (18) parcourue par le courant $I_A$ et à une branche (23) d'une troisième ligne de courant parcourue par la somme des courants $I_B+I_{Cin}$ de sorte que les courants $I_B+I_{Cin}$ et $I_A$ soient sommés avant d'être acheminés sur ladite première ligne de courant (32) engendrant un champ magnétique au voisinage desdits premier et deuxième empilements (MTJ3, MTJ4).

12. Additionneur (9) selon la revendication 11 **caractérisé en ce que** ladite partie magnétique (3) de génération de ladite somme comporte :

- un troisième empilement magnétorésistif (MTJ1) incluant une couche ferromagnétique dure et une couche ferromagnétique douce séparées par une couche intercalaire non ferromagnétique, la couche ferromagnétique dure étant piégée dans un état magnétique fixe qui sert de référence,
- un quatrième empilement magnétorésistif (MTJ2) incluant une couche ferromagnétique dure et une couche ferromagnétique douce séparées par une couche intercalaire non ferromagnétique, la couche ferromagnétique dure étant piégée dans un état magnétique fixe qui sert de référence,
- une troisième et quatrième ligne de courant (17, 19), lesdites deuxième, troisième et quatrième lignes de courant (18, 17, 19) appartenant respectivement à un premier, un deuxième et un troisième niveau de métallisation (N2, N1, N3),
- un troisième, un quatrième et un cinquième via conducteur (20, 21, 22) vertical d'accès à ladite interface d'entrée (2) connectés électriquement respectivement auxdites deuxième, troisième et quatrième ligne de courant (18, 17, 19) de sorte que ledit troisième via vertical (20) injecte le courant $I_B$ dans ladite troisième ligne (17), ledit quatrième via vertical (21) injecte le courant $I_A$ dans ladite deuxième ligne (18) et ledit cinquième via vertical (22) injecte le courant $I_{Cin}$ dans ladite quatrième ligne de courant (19),

ladite deuxième ligne de courant (18) engendrant un champ magnétique au voisinage desdits troisième et quatrième empilement (MTJ1, MTJ2) et étant située à une distance d suivant l'axe vertical des couches douces de chacun desdits troisième et quatrième empilement (MTJ1, MTJ2),
ladite troisième ligne de courant (17) engendrant un champ magnétique au voisinage dudit troisième empilement (MTJ1) et étant située à une distance 2xd suivant l'axe vertical de la couche douce dudit troisième empilement (MTJ1),
ladite quatrième ligne de courant (19) engendrant un champ magnétique au voisinage desdits troisième et quatrième empilement (MTJ1, MTJ2) et étant située à une distance 2xd suivant l'axe vertical des couches douces de chacun desdits troisième et quatrième empilement (MTJ1, MTJ2),
ladite troisième ligne de courant (17) étant reliée électriquement à ladite quatrième ligne de courant (19) grâce à un via d'interconnexion vertical (25) de sorte que les courants $I_B$ et $I_{Cin}$ desdites troisième et quatrième lignes (17, 19) soient sommés avant d'être acheminés sur la branche (23) de ladite quatrième ligne de courant (19) engendrant un champ magnétique au voisinage dudit quatrième empilement (MTJ2),
ladite deuxième ligne de courant (18) étant sensiblement perpendiculaire aux dites troisième et quatrième lignes de courant (17, 19) au voisinage dudit troisième empilement (MTJ1) et ladite deuxième ligne de courant (18) étant sensiblement perpendiculaire à ladite quatrième ligne de courant (19) au voisinage dudit quatrième empilement (MTJ2).

13. Additionneur (109) incorporant un dispositif selon l'une des revendications 1 à 10, ledit additionneur (109) comprenant :

- une interface d'entrée de signaux de courant $I_{A0}$, $I_{B0}$ et $I_{Cin0}$ alimentant trois lignes d'interconnexions,
- une structure magnétique comprenant :

○ une partie magnétique (103) de génération de ladite somme comportant :

■ un premier empilement magnétorésistif (MTJ1) incluant une couche ferromagnétique dure et une couche ferromagnétique douce séparées par une couche intercalaire non ferromagnétique, la couche ferromagnétique dure étant piégée dans un état magnétique fixe qui sert de référence,
■ un deuxième empilement magnétorésistif (MTJ2) incluant une couche ferromagnétique dure et une couche ferromagnétique douce séparées par une couche intercalaire non ferromagnétique, la couche ferromagnétique dure étant piégée dans un état magnétique fixe qui sert de référence,
■ une première, une deuxième et une troisième ligne de courant (117, 118, 119) appartenant respectivement à un premier, un deuxième et un troisième niveau de métallisation (N1, N2, N3),
■ un premier, un deuxième et un troisième via conducteur (120, 121, 122) vertical d'accès à ladite interface d'entrée (2) connectés électriquement respectivement auxdites première, deuxième et troisième ligne de courant (117, 118, 119) de sorte que le premier via vertical (120) injecte le courant $I_B$ dans ladite première ligne (117), ledit deuxième via vertical (121) injecte le courant $I_A$ dans ladite deuxième ligne (118) et ledit troisième via vertical (122) injecte le courant $I_{Cin}$ dans ladite troisième ligne (119),

ladite deuxième ligne de courant (118) engendrant un champ magnétique au voisinage desdits premier et deuxième empilement (MTJ1, MTJ2) et étant située à une distance d suivant l'axe vertical des couches douces de chacun desdits premier et deuxième empilement (MTJ1, MTJ2),

ladite première ligne de courant (117) engendrant un champ magnétique au voisinage dudit premier empilement (MTJ1) et étant située à une distance 2xd suivant l'axe vertical de la couche douce dudit premier empilement (MTJ1),

ladite troisième ligne de courant (119) engendrant un champ magnétique au voisinage desdits premier et deuxième empilement (MTJ1, MTJ2) et étant située à une distance 2xd suivant l'axe vertical des couches douces de chacun desdits premier et deuxième empilement (MTJ1, MTJ2),

ladite première ligne de courant (117) étant reliée électriquement à ladite troisième ligne de courant (119) grâce à un via d'interconnexion vertical (125) de sorte que les courants $I_B$ et $I_{Cin}$ desdites première et troisième lignes (117, 119) soient sommés avant d'être acheminés sur la branche (123) de ladite troisième ligne de courant (119) engendrant un champ magnétique au voisinage dudit deuxième empilement (MTJ2),

ladite deuxième ligne de courant (118) étant sensiblement perpendiculaire aux dites première et troisième lignes de courant (117, 119) au voisinage dudit premier empilement (MTJ1) et ladite deuxième ligne de courant (118) étant sensiblement perpendiculaire à ladite troisième ligne de courant (119) au voisinage dudit deuxième empilement (MTJ2),

o une quatrième ligne de courant (132), dite ligne de propagation de retenue, appartenant au dit premier niveau de métallisation (N1),

○ un quatrième et un cinquième via conducteur vertical (135, 136) reliant électriquement ladite quatrième ligne de courant (132) respectivement à ladite deuxième ligne de courant (118) parcourue par le courant $I_A$ et à ladite branche (123) de ladite troisième ligne de courant parcourue par la somme des courants $I_B+I_{Cin}$ de sorte que les courants $I_B+I_{Cin}$ et $I_A$ soient sommés avant d'être acheminés sur ladite quatrième ligne de courant (132),

○ une cinquième ligne de courant (419) appartenant à un niveau de métallisation (N3) différent dudit premier niveau de métallisation (N1) et apte à produire un champ magnétique au voisinage d'un empilement magnétorésistif (MTJ1', MTJ2'),

○ un sixième via conducteur vertical (422) reliant électriquement ladite quatrième ligne de courant (132) à ladite cinquième ligne de courant (419).

**14.** Additionneur (109) selon la revendication 13 **caractérisé en ce qu'**il comporte :

- un septième via conducteur vertical (438) reliée électriquement à ladite ligne de propagation de retenue (132);
- un circuit limiteur (500) de courant pour limiter la valeur absolue du courant circulant dans ladite ligne de propagation de retenue (132), ledit circuit limiteur (500) de courant étant relié à ladite ligne de propagation (132) par ledit septième via conducteur (438).

**15.** Additionneur selon la revendication 14 **caractérisé en ce que** ledit circuit limiteur (500) comporte trois transistors PMOS (501, 502, 503) et trois transistors NMOS (504, 505, 506) montés en série, le premier transistor PMOS (501) et le troisième transistor NMOS (506) ayant leur grille commune, le deuxième transistor PMOS (502) et le deuxième transistor NMOS (505) ayant leur grille commune, le troisième transistor PMOS (503) et le premier transistor NMOS (504) ayant leur grille commune, le drain commun du premier transistor NMOS (504) et du troisième transistor PMOS (503) étant connecté à ladite ligne de propagation de la retenue (132) par ledit septième via conducteur vertical (438).

## Patentansprüche

**1.** Vorrichtung (9) zur Realisierung einer "logischen Funktion", umfassend eine magnetische Struktur, umfassend:

- wenigstens eine erste magnetoresistive Stapelung (MTJ3), die eine erste ferromagnetische Schicht und eine zweite ferromagnetische Schicht einschließt, die durch eine nicht ferromagnetische Zwischenschicht getrennt sind, wobei die zweite Schicht eine weiche ferromagnetische Schicht ist, während die erste Schicht eine in einem als Referenz dienenden magnetischen Zustand gefangene harte ferromagnetische Schicht ist,
- wenigstens eine erste Stromleitung (32), die sich in der Nachbarschaft der genannten ersten magnetoresistiven Stapelung (MTJ3) befindet und in der Nachbarschaft der genannten ersten Stapelung (MTJ3) ein Magnetfeld generiert, wenn sie von einem elektrischen Strom durchquert wird,

wobei die genannte erste Leitung (32) für die genannte wenigstens eine Stapelung wenigstens zwei Stromeingangspunkte derart umfasst, dass zwei Ströme sich in der genannten ersten Leitung (32) summieren, wobei die Summe der genannten zwei Ströme durch die genannte logische Funktion bestimmt wird,

wobei die genannte Vorrichtung (9) **dadurch gekennzeichnet ist, dass** die genannte erste Leitung (32) an wenigstens eine andere Stromleitung (19, 18) angeschlossen ist, die zu einem von dem Metallisierungsniveau der genannten ersten Leitung (32) unterschiedlichen Metallisierungsniveau gehört, wobei die zwei Leitungen durch eine leitende Verbundlinie (36, 35) verbunden sind und der Verbindungspunkt zwischen der genannten Verbundleitung (36, 35) und der genannten ersten Leitung (32) einen der genannten zwei Stromeingangspunkte bildet.

2.

Vorrichtung (9) gemäß dem voranstehenden Anspruch, **dadurch gekennzeichnet, dass** die genannten wenigstens zwei Stromeingangspunkte jeweils einen Strom $I_1$ und $I_2$ in die genannte erste Leitung derart einschießen, dass die Intensität H' des von der genannten ersten Leitung generierten Feldes in der Nachbarschaft der genannten weichen Schicht derart ist, dass $\frac{H'}{H} = \frac{I_1 + I_2}{I}$, wobei H die Intensität des Magnetfeldes ist, das von der genannten ersten Stromleitung generiert wird, wenn diese von einem Strom I durchquert wird.

3. Vorrichtung (9) gemäß einem der voranstehenden Ansprüche, **dadurch gekennzeichnet, dass** sie umfasst:

   - wenigstens eine zweite magnetoresistive Stapelung (MTJ1), die entweder mit der genannten ersten Stapelung zusammenfallen kann oder von der genannten ersten Stapelung unterschiedlich sein kann, wobei die genannte zweite Stapelung eine erste ferromagnetische Schicht und eine zweite ferromagnetische Schicht umfasst, die durch eine nicht ferromagnetische Zwischenschicht getrennt sind,
   - wenigstens zwei Stromleitungen (18, 19), die jeweils zu einem ersten (N3) und zweiten (N2) Metallisierungsniveau gehören, wobei jede der genannten zwei Leitungen ein Magnetfeld in der Nachbarschaft der genannten zweiten Stapelung umfasst, wenn sie von einem elektrischen Strom durchquert werden,

   wobei die genannten zwei Leitungen (18, 19) in von der genannten zweiten ferromagnetischen Schicht der genannten zweiten Stapelung (MTJ1) unterschiedlichen Entfernungen angeordnet sind.

4. Vorrichtung (9) gemäß dem voranstehenden Anspruch, **dadurch gekennzeichnet, dass** die genannten zwei Leitungen (18, 19) sich auf jeder Seite der genannten zweiten magnetoresistiven Stapelung (MTJ1) befinden.

5. Vorrichtung (9) gemäß Anspruch 3 oder 4, **dadurch gekennzeichnet, dass** eine der genannten zwei Leitungen sich in einer Entfernung d1 oberhalb der genannten zweiten Schicht befindet und die andere der genannten zwei Leitungen sich in einer Entfernung d2 unterhalb der genannten zweiten Schicht derart befindet, dass bei zwei Strömen derselben Intensität, die jeweils in der einen und der anderen der zwei Leitungen zirkulideren, die Intensitäten H1 und H2 der Felder, die jeweils von der sich in der Entfernung d1 befindenden Leitung und von der sich in der Entfernung d2 in der Nachbarschaft der genannten zweiten Schicht befindenden Leitung generierte Felder derart sind, dass: $\frac{H_1}{H_2} = \frac{d_2}{d_1}$.

6. Vorrichtung (9) gemäß einem der voranstehenden Ansprüche, **dadurch gekennzeichnet, dass** sie umfasst:

   - wenigstens eine magnetoresistive Stapelung (MTJ1), die eine erste ferromagnetische Schicht und eine zweite ferromagnetische Schicht einschließt, die durch eine nicht ferromagnetische Zwischenschicht getrennt sind,
   - wenigstens zwei Stromleitungen (19, 17), die jeweils zu einem ersten (N3) und einem zweiten (N1) Metallisierungsniveau gehören, wobei jede der genannten zwei Leitungen ein Magnetfeld in der Nachbarschaft der genannten wenigstens einen Stapelung generiert, wenn sie von einem elektrischen Strom durchquert werden,

   wobei die genannten zwei Leitungen (19, 17) auf jeder Seite der genannten zweiten ferromagnetischen Schicht in gleicher Entfernung angeordnet sind.

7. Vorrichtung (9) gemäß einem der voranstehenden Ansprüche, **dadurch gekennzeichnet, dass** die erste oder ersten ferromagnetische(n) Schicht(en) harte ferromagnetische Schicht(en) ist (sind), die in einem magnetischen Zustand gefangen ist (sind), der als Referenz dient und die zweite oder zweiten ferromagnetische(n) Schicht(en) weiche ferromagnetische Schicht(en) ist (sind).

8. Vorrichtung gemäß Anspruch 7, **dadurch gekennzeichnet, dass** die harte Schicht jeder magnetoresistiven Stapelung in einem zu einer Achse leichter Magnetisierung lotrechten magnetischen Zustand gefangen ist, der für die weiche Schicht derselben Stapelung als Referenz dient, wobei diese weiche Schicht der magnetoresistiven Stapelung eine magnetische Ausrichtung aufweist, die durch den Strom modulierbar ist, der aus der oder den Stromleitung (en) stammt, die sich in der Nachbarschaft der magnetoresistiven Stapelung derart befindet (befinden), dass eine ausreichende Modifizierung des transversalen Widerstandes der Stapelung generiert wird, um ein elektrisches Signal auszulösen, wobei diese Modulation der magnetischen Ausrichtung der weichen Schicht der Stapelung ausreichend schwach ist, damit diese Ausrichtung nicht zwischen zwei stabilen Positionen kippt, sondern um eine stabile Position fluktuiert.

9. Vorrichtung gemäß einem der voranstehenden Ansprüche, **dadurch gekennzeichnet, dass** sie eine Eingangsschnittstelle (2) umfasst, umfassend:

   - wenigstens einen Eingang, der eine kodifizierte logische Information in Form eines eine logische "0" oder eine logische "1" darstellendes Spannungsniveau empfängt;
   - wenigstens einen an eine leitende Verbundleitung angeschlossenen Ausgang;
   - elektronische Mittel zum Generieren eines Stroms in der genannten leitenden Verbundleitung, dessen Richtung für die logische Information repräsentativ ist, wobei der absolute Wert der Intensität des genannten Stroms in der einen oder der anderen Richtung des genannten Stroms identisch ist.

10. Vorrichtung gemäß Anspruch 1 bis 9, **dadurch gekennzeichnet, dass** sie umfasst:

   - eine zweite magnetoresistive Stapelung, die eine erste ferromagnetische Schicht und eine zweite ferromagnetische Schicht einschließt, die durch eine nicht ferromagnetische Zwischenschicht getrennt sind;
   - eine Ausgangsschnittstelle (4), die elektrisch an die genannten ersten und zweiten magnetoresistiven Stapelungen angeschlossen ist, wobei die genannte Schnittstelle umfasst:

      o einen ersten Eingang, der an eine leitende Verbundleitung angeschlossen ist, die elektrisch den genannten ersten Eingang mit der genannten magnetoresistiven Stapelung verbindet;
      o einen zweiten Eingang, der an eine leitende Verbundleitung angeschlossen ist, die elektrisch den genannten zweiten Eingang mit der genannten magnetoresistiven Stapelung verbindet;
      o Mittel zum Generieren eines Differentialstroms ($\Delta i_{read}$) zwischen dem Strom, der in der genannten ersten Stapelung zirkuliert und dem Strom, der in der genannten zweiten Stapelung zirkuliert, wenn diese einer Polarisationsspannung unterworfen sind, wobei der genannte Differentialstrom für eine logische Information repräsentativ ist;
      o Mittel zum Generieren einer Spannung (S), die die genannte logische Information in Abhängigkeit von dem genannten Differentialstrom generiert.

11. Summator (9), der eine Vorrichtung gemäß Anspruch 1 bis 10 beinhaltet, wobei der genannte Summator (9) umfasst:

   - Eine Eingangsschnittstelle (2) von Stromsignalen $I_A$, $I_B$ und $I_{Cin}$, die drei Verbundleitungen versorgen,
   - eine Magnetstruktur, umfassend:

      o einen magnetischen Generierungsteil (3) der genannten Summe,
      ○ einen magnetischen Generierungsteil (5) des genannten Abzugs,

wobei der genannte magnetische Generierungsteil (5) des genannten Abzugs umfasst:

   - eine erste magnetoresistive Stapelung (MTJ3), die eine harte ferromagnetische Schicht und eine weiche ferromagnetische Schicht einschließt, die durch eine nicht ferromagnetische Schicht getrennt sind, wobei die harte ferromagnetische Schicht in einem festen magnetischen Zustand gefangen ist, der als Referenz dient,
   - eine zweite magnetoresistive Schicht (MTJ4), die eine harte ferromagnetische Schicht und eine weiche ferromagnetische Schicht einschließt, die durch eine nicht ferromagnetische Zwischenschicht getrennt sind, wobei die harte ferromagnetische Schicht in einem festen magnetischen Zustand gefangen ist, der als Referenz dient,
   - eine erste Stromleitung (32), die ein Magnetfeld in der Nachbarschaft der genannten ersten und zweiten Stapelung (MTJ3, MTJ4) generiert und sich in einer Entfernung d gemäß der vertikalen Achse der weichen Schichten jeder der ersten und dritten Stapelung (MTJ3, MTJ4) befindet,

- einen ersten und einen zweiten vertikalen Leitersteg (35, 36), die elektrisch die genannte erste Stromleitung (32) jeweils mit einer zweiten Stromleitung (18), die von dem Strom $I_A$ durchströmt wird, und einem Zweig (23) einer dritten Stromleitung, die von der Summe des Ströme $I_B + I_{Cin}$ derart durchströmt wird, dass die Ströme $I_B + I_{Cin}$ und $I_A$ summiert werden, bevor sie auf der genannte ersten Stromleitung (32) weitergeleitet werden und ein Magnetfeld in der Nachbarschaft der genannten ersten und zweiten Stapelungen (MTJ3, MTJ4) generieren, verbinden.

**12.** Summator (9) gemäß Anspruch 11, **dadurch gekennzeichnet, dass** der genannte magnetische Generierungsteil (3) der genannten Summe umfasst:

- eine dritte magnetoresistive Stapelung (MTJ1), die eine harte ferromagnetische Schicht und eine weiche ferromagnetische Schicht einschließt, die durch eine nicht ferromagnetische Zwischenschicht getrennt sind, wobei die harte ferromagnetische Schicht in einem festen magnetischen Zustand gefangen ist, der als Referenz dient,

- eine vierte magnetoresistive Stapelung (MTJ2), die eine harte ferromagnetische Schicht und eine weiche ferromagnetische Schicht einschließt, die durch eine nicht ferromagnetische Zwischenschicht getrennt sind, wobei die harte ferromagnetische Schicht in einem festen magnetischen Zustand gefangen ist, der als Referenz dient,

- eine dritte und vierte Stromleitung (17, 19), wobei die genannten zweiten, dritten und vierten Stromleitungen (18, 17, 19) jeweils zu einem ersten, einem zweiten und einem dritten Metallisierungsniveau (N2, N1, N3) gehören,

- einen dritten, einen vierten und einen fünften vertikalen Leitersteg (20, 21, 22) zum Zugang zu der genannten Eingangsschnittstelle (2), die jeweils elektrisch an die genannten zweiten, dritten und vierten Stromleitungen (18, 17, 19) derart angeschlossen sind, dass der genannte dritte vertikale Steg (20) den Strom $I_B$ in die genannte dritte Leitung (17) einschießt, wobei der genannte vierte vertikale Steg (21), den Strom $I_A$ in die genannte zweite Leitung (18) einschießt und der genannte fünfte vertikale Steg (22) den Strom $I_{Cin}$ in die genannte vierte Stromleitung (19) einschießt,

wobei die genannte zweite Stromleitung (18) ein Magnetfeld in der Nachbarschaft der genannten dritten und vierten Stapelung (MTJ1, MTJ2) generiert und sich in einer Entfernung d gemäß der vertikalen Achse der weichen Schichten jeder der dritten und vierten Stapelung (MTJ1, MTJ2) befindet,

wobei die dritte Stromleitung (17) ein Magnetfeld in der Nachbarschaft der genannten dritten Stapelung (MTJ1) generiert und sich in einer Entfernung 2xd gemäß der vertikalen Achse der weichen Schicht der genannten dritten Stapelung (MTJ1) befindet,

wobei die genannte vierte Stromleitung (19) ein Magnetfeld in der Nachbarschaft der genannten dritten und vierten Stapelung (MTJ1, MTJ2) generiert und sich in einer Entfernung 2xd gemäß der vertikalen Achse der weichen Schichten jeder der genannten dritten und vierten Stapelungen (MTJ1, MTJ2) befindet,

wobei die genannte dritte Stromleitung (17) dank eines vertikalen Verbundstegs (25) derart elektrisch mit der genannten vierten Stromleitung (19) verbunden ist, das die Ströme $I_B$ und $I_{Cin}$ der genannten dritten und vierten Leitungen (17, 19) summiert werden, bevor sie auf dem Zweig (23) der genannten vierten Stromleitung (19) weitergeleitet werden und ein Magnetfeld in der Nachbarschaft der genannten vierten Stapelung (MTJ2) generieren,

wobei die genannte zweite Stromleitung (18) deutlich lotrecht zu den genannten dritten und vierten Stromleitungen (17, 19) in der Nachbarschaft der genannten dritten Stapelung (MTJ1) ist und die genannte zweite Stromleitung (18) deutlich lotrecht zur genannten vierten Stromleitung (19) in der Nachbarschaft der genannten vierten Stapelung (MTJ2) ist.

**13.** Summator (109), der eine Vorrichtung gemäß Anspruch 1 bis 10 beinhaltet, wobei der genannte Summator (109) umfasst:

- eine Eingangsschnittstelle von Signalen des Stroms $I_{A0}$, $I_{B0}$ und $I_{Cin0}$, der drei Verbundlinien versorgt,
- eine magnetische Struktur, umfassend:

  ○ einen magnetischen Generierungsteil (103) der genannten Summe, umfassend:

    • eine erste magnetoresistive Stapelung (MTJ1), die eine harte ferromagnetische Schicht und eine weiche ferromagnetische Schicht einschließt, die durch eine nicht ferromagnetische Schicht getrennt sind, wobei die harte ferromagnetische Schicht in einem festen magnetischen Zustand gefangen ist, der als Referenz dient,

• eine zweite magnetoresistive Stapelung (MTJ2), die eine harte ferromagnetische Schicht und eine weiche ferromagnetische Schicht einschließt, die durch eine nicht ferromagnetische Schicht getrennt sind, wobei die harte ferromagnetische Schicht in einem festen magnetischen Zustand gefangen ist, der als Referenz dient,

• eine erste, eine zweite und eine dritte Stromleitung (117, 118, 119), die jeweils zu einem ersten, einem zweiten und einem dritten Metallisierungsniveau (N1, N2, N3) gehören,

• einen ersten, einen zweiten und einen dritten vertikalen Stegleiter (120, 121, 122) für den Zugang zur genannten Eingangsschnittstelle (2), die jeweils elektrisch an die genannten ersten, zweiten und dritten Stromleitungen (117, 118, 119) derart angeschlossen sind, dass der erste vertikale Steg (120) den Strom $I_A$ in die genannte erste Leitung (117) einschießt, der genannte zweite vertikale Steg (121) den Strom $I_A$ in die genannte zweite Leitung (118) einschießt und der dritte vertikale Steg (122) den Strom $I_{Cin}$ in die genannte dritte Leitung einschießt (119),

wobei die genannte zweite Stromleitung (118) ein Magnetfeld in der Nachbarschaft der genannten ersten und zweiten Stapelung (MTJ1, MTJ2) generiert und sich in einer Entfernung d gemäß der vertikalen Achse der weichen Schichten jeder der genannten ersten und zweiten Stapelungen (MTJ1, MTJ2) befindet,

wobei die genannte erste Stromleitung (117) ein Magnetfeld in der Nachbarschaft der genannten ersten Stapelung (MTJ1) generiert und sich in einer Entfernung 2xd gemäß der vertikalen Achse der weichen Schicht der genannten ersten Stapelung (MTJ1) befindet,

wobei die genannte dritte Stromleitung (119) ein Magnetfeld in der Nachbarschaft der genannten ersten und zweiten Stapelung (MTJ1, MTJ2) generiert und sich in einer Entfernung 2xd gemäß der vertikalen Achse der weichen Schichten jeder der genannten ersten und zweiten Stapelung (MTJ1, MTJ2) befindet,

wobei die genannte erste Stromleitung (117) dank eines vertikalen Verbundstegs (125) derart elektrisch an die genannte dritte Stromleitung (119) angeschlossen ist, dass die Ströme $I_B$ und $I_{Cin}$ der genannten ersten und dritten Leitungen (117, 119) summiert werden, bevor sie auf dem Zweig (123) der genannten dritten Stromleitung (119) weitergeleitet werden und ein Magnetfeld in der Nachbarschaft der genannten zweiten Stapelung (MTJ2) generieren,

wobei die genannte zweite Stromleitung (118) deutlich lotrecht zu genannten ersten und zweiten Stromleitungen (117, 119) in der Nachbarschaft der genannten ersten Stapelung (MTJ1) und die genannte zweite Stromleitung (118) deutlich lotrecht zu der genannten dritten Stromleitung (119) in der Nachbarschaft der genannten zweiten Stapelung (MTJ2) ist,

○ wobei eine vierte, als Rückhalteverbreitungsleitung bezeichnete Stromleitung (132), zu dem genannten ersten Metallisierungsniveau (N1) gehört,

○ wobei ein vierter und ein fünfter vertikaler Leitersteg (135, 136) die genannte vierte Stromleitung (132) jeweils mit der genannten, mit dem Strom $I_A$ durchströmten zweiten Stromleitung (118) und den genannten Zweig (123) der genannten dritten Stromleitung verbindet, der mit der Summe der Ströme $I_B + I_{Cin}$ derart durchströmt wird, dass die Ströme $I_B + I_{Cin}$ und $I_A$ summiert werden, bevor sie auf der genannten vierten Stromleitung (132) weitergeleitet werden,

○ wobei eine fünfte Stromleitung (419), die zu einem von dem genannten ersten Metallisierungsniveau (N1) unterschiedlichen Metallisierungsniveau (N3) gehört und geeignet ist, ein Magnetfeld in der Nachbarschaft einer magnetoresistiven Stapelung (MTJ1'; MTJ2') zu produzieren,

○ wobei ein sechster vertikaler Leiter (422) die genannte vierte Stromleitung (132) elektrisch mit der genannten fünften Stromleitung (419) verbindet.

**14.** Summator (109) gemäß Anspruch 13, **dadurch gekennzeichnet, dass** er umfasst:

- Einen siebten vertikalen Steg (438), der elektrisch mit der genannten Rückhalteverbreitungsleitung (132) verbunden ist;
- Einen Begrenzungsschaltkreis (500) des Stroms zur Begrenzung des absoluten Wertes des Stroms, der in der genannten Rückhalteverbreitungsleitung (132) zirkuliert, wobei der genannte Begrenzungsschaltkreis (500) des Stroms mit der genannten Verbreitungsleitung (132) durch den genannten siebten Leitersteg (438) verbunden ist.

**15.** Summator gemäß Anspruch 14, **dadurch gekennzeichnet, dass** der genannte Begrenzungsschaltkreis (500) drei Transistoren PMOS (501, 502, 503) und drei in Serie geschaltete Transistoren NMOS (504, 505, 506) umfasst, wobei der erste Transistor PMOS (501) und der dritte Transistor NMOS (506) ein gemeinsames Gitter haben, wobei der zweite Transistor PMOS (502) und der zweite Transistor NMOS (505) ein gemeinsames Gitter haben, wobei der dritte Transistor PMOS (503) und der erste Transistor NMOS (504) ein gemeinsames Gitter haben, wobei die gemeinsame Drainzone des ersten Transistors NMOS (504) und des dritten Transistors PMOS (503) an die genannte Verbreitungsleitung des Rückhalts (132) durch den genannten siebten vertikalen Stegleiter (438) angeschlossen ist.

**Claims**

1. Device (9) for performing a "logic function", comprising a magnetic structure comprising:

   - at least a first magnetoresistive stack (MTJ3) including a first ferromagnetic layer and a second ferromagnetic layer separated by a nonferromagnetic intermediate layer, the second layer being a soft ferromagnetic layer while the first layer is a hard ferromagnetic layer pinned in a fixed magnetic state used as a reference;
   - at least a first current line (32) located in the vicinity of said first magnetoresistive stack (MTJ3) and generating a magnetic field in the vicinity of said first stack (MTJ3) when an electrical current passes through it,

   said first line (32) comprising at least two current input points for said at least one stack, such that two currents are added into said first line (32), the sum of said two currents being determined by said logic function;
   said device (9) being **characterised in that** said first line (32) is connected to at least one other current line (19, 18) belonging to a different metallisation level than the metallisation level of said first line (32), the two lines being connected by an interconnecting conducting line (36, 35) and the connection point between said interconnecting line (36, 35) and said first line (32) forming one of said two current input points.

2. Device (9) according to the previous claim, **characterised in that** said at least two current input points inject currents $I_1$ and $I_2$ into said first line such that the field intensity H' generated by said first line in the vicinity of said soft layer is such that $\dfrac{H'}{H} = \dfrac{I_1 + I_2}{I}$ where H is the intensity of the magnetic field generated by said first current line when a current I passes through it.

3. Device (9) according to one of the previous claims, **characterised in that** it comprises:

   - at least a second magnetoresistive stack (MTJ1) that may be coincident with said first stack or it may be different from said first stack, said second stack including a first ferromagnetic layer and a second ferromagnetic layer separated by an intermediate non-ferromagnetic layer;
   - at least two current lines (18, 19) belonging to a first metallisation level (N3) and a second metallisation level (N2) respectively, each of said two lines generating a magnetic field in the vicinity of said second stack when an electrical current passes through them;

   said two lines (19, 18) being arranged at different distances from said second ferromagnetic layer of said second stack (MTJ1).

4. Device (9) according to the previous claim, **characterised in that** said two lines (18, 19) are located on each side of said second magnetoresistive stack (MTJ1).

5. Device (9) according to claim 3 or 4, **characterised in that** one of said two lines is located at a distance d1 above said second layer and the other of said two lines is located at a distance d2 below said second layer, such that for two currents with the same intensity circulating in each of said two lines, the intensities H1 and H2 of the fields generated by the line at distance d1 and by the line at distance d2 respectively close to said second layer are such

   that $\dfrac{H_1}{H_2} = \dfrac{d_2}{d_1}$ .

6. Device (9) according to one of the previous claims, **characterised in that** it comprises:

   - at least a magnetoresistive stack (MTJ1) including a first ferromagnetic layer and a second ferromagnetic layer separated by an intermediate non-ferromagnetic layer,
   - at least two current lines (19, 17) belonging to a first metallisation level (N3) and a second metallisation level (N1) respectively, each of said two lines generating a magnetic field in the vicinity of said at least one stack when an electrical current passes through them;

said two lines (19, 17) being arranged at an equal distance on each side of said second ferromagnetic layer.

7. Device (9) according to one of the previous claims, **characterised in that** the first ferromagnetic layer(s) is (are) hard ferromagnetic layers pinned in a fixed magnetic state that acts as a reference and the second ferromagnetic layer(s) is (are) soft ferromagnetic layers.

8. Device according to claim 7, **characterised in that** the hard layer in each of the magnetoresistive stacks is pinned in a magnetic state perpendicular to an axis of easy magnetisation used as a reference for the soft layer in this stack, this soft layer in the magnetoresistive stack having a magnetic orientation that can be modulated by the current issuing from the current line(s) located in the vicinity of the magnetoresistive stack so as to induce a sufficient modification to the transverse resistance of the stack to set off an electrical signal, this modulation of the magnetic orientation of the soft layer in the stack being sufficiently weak so that this orientation does not change between two stable positions, but fluctuates around a stable position.

9. Device according to one of the previous claims, **characterised in that** it comprises an input interface (2) comprising:

- at least one input receiving logical information coded in the form of a voltage level representing a logical "0" or "1";
- at least one output connected to an interconnecting conducting line;
- electronic means of generating a current in said interconnecting conducting line, the direction of which is representative of the logical information, the absolute value of the intensity of said current being identical along one direction or along the other direction of said current.

10. Device according to one of claims 1 to 9, **characterised in that** it comprises:

- a second magnetoresistive stack including a first ferromagnetic layer and a second ferromagnetic layer separated by an intermediate non-ferromagnetic layer;
- an output interface (4) electrically connected to said first and second magnetoresistive stacks, said interface comprising:
- a first input connected to an interconnecting conducting line electrically connecting said first input to said first magnetoresistive stack;
- a second input connected to an interconnecting conducting line electrically connecting said second input to said second magnetoresistive stack;
- means of generating a differential current ($\Delta I_{read}$) between the current circulating in said first stack and the current circulating in said second stack when a bias voltage is applied to these stacks, said differential current being representative of logical information;
- means of generating a voltage (S) representative of said logical information as a function of said differential current.

11. Adder (9) comprising a device according to one of claims 1 to 10, said adder (9) comprising:

- an input interface (2) for current signals $I_A$, $I_B$, and $I_{Cin}$ flowing through three interconnecting lines;
- a magnetic structure comprising:

  . a magnetic part (3) generating said sum;
  . a magnetic part (5) generating said carry;

said magnetic part (5) generating said carry comprising:

- a first magnetoresistive stack (MTJ3) including a hard ferromagnetic layer and a soft ferromagnetic layer separated by an intermediate non-ferromagnetic layer, the hard ferromagnetic layer being pinned in a fixed magnetic state that is used as a reference;
- a second magnetoresistive stack (MTJ4) including a hard ferromagnetic layer and a soft ferromagnetic layer separated by an intermediate non-ferromagnetic layer, the hard ferromagnetic layer being pinned in a fixed magnetic state that is used as a reference;
- a first current line (32) generating a magnetic field in the vicinity of said first and second stacks (MTJ3, MTJ4) and being located at a distance d along the vertical axis of the soft layers in each of said first and third stacks (MTJ3, MTJ4);
- a first and a second vertical conducting via (35, 36) electrically connecting said first current line (32) to a second current line (18) through which the current $I_A$ passes, and to a branch (23) of a third current line through which the sum of currents $I_B + I_{Cin}$ passes respectively, such that currents $I_B + I_{Cin}$ and $I_A$ are added together before being routed on said first current line (32) generating a magnetic field in the vicinity of said first and second stacks (MTJ3, MTJ4).

12. Adder (9) according to claim 11, **characterised in that** said magnetic part (3) generating said sum comprises:

- a third magnetoresistive stack (MTJ1) including a hard ferromagnetic layer and a soft ferromagnetic layer separated by an intermediate non-ferromagnetic layer, the hard ferromagnetic layer being pinned in a fixed magnetic state that is used as a reference;
- a fourth magnetoresistive stack (MTJ2) including a hard ferromagnetic layer and a soft ferromagnetic layer separated by an intermediate non-ferromagnetic layer, the hard ferromagnetic layer being pinned in a fixed magnetic state that is used as a reference;
- a third and a fourth current line (17, 19), said second, third and fourth current lines (18, 17, 19) belonging to first, second and third metallisation levels (N2, N1, N3) respectively;
- a third, a fourth, and a fifth conducting via (20, 21, 22) with vertical access to said input interface (2) electrically connected to said second, third and fourth current lines (18, 17, 19) respectively such that the third vertical via (20) injects current $I_B$ into said third line (17), said fourth vertical via (21) injects current $I_A$ into said second line (18) and said fifth vertical via (22) injects current $I_{Cin}$ into said fourth current line (19);

said second current line (18) generating a magnetic field in the vicinity of said third and fourth stacks (MTJ1, MTJ2) and being located at a distance d along the vertical axis of the soft layers in said third and fourth stacks (MTJ1, MTJ2);
said third current line (17) generating a magnetic field in the vicinity of said third stack (MTJ1) and being located at a distance 2xd along the vertical axis of the soft layer of said third stack (MTJ1);
said fourth current line (19) generating a magnetic field in the vicinity of third and fourth stacks (MTJ1, MTJ2) and being located at a distance 2xd along the vertical axis of the soft layers in each of said third and fourth stacks (MTJ1, MTJ2);
said third current line (17) being electrically connected to said fourth current line (19) through a vertical interconnecting via (25) such that currents $I_B$ and $I_{Cin}$ in said third and fourth lines (17, 19) are added together before being routed on the branch (23) of said fourth current line (19) generating a magnetic field in the vicinity of said fourth stack (MTJ2);
said second current line (18) being approximately perpendicular to said third and fourth current lines (17, 19) in the vicinity of said third stack (MTJ1) and said second current line (18) being approximately perpendicular to said fourth current line (19) in the vicinity of said fourth stack (MTJ2).

13. Adder (109) comprising a device according to one of claims 1 to 10, said adder (109) comprising:

- an input interface for the current signals $I_{A0}$, $I_{B0}$ and $I_{Cin0}$ flowing through three interconnecting lines;
- a magnetic structure comprising:

. a magnetic part (103) generating said sum, comprising:

- a first magnetoresistive stack (MTJ1) including a hard ferromagnetic layer and a soft ferromagnetic layer separated by an intermediate non-ferromagnetic layer, the hard ferromagnetic layer being pinned in a fixed magnetic state that is used as a reference;
- a second magnetoresistive stack (MTJ2) including a hard ferromagnetic layer and a soft ferromagnetic layer separated by an intermediate non-ferromagnetic layer, the hard ferromagnetic layer being pinned in a fixed magnetic state that is used as a reference;
- a first, a second and a third current line (117, 118, 119) belonging to a first, a second and a third metallisation level (N1, N2, N3) respectively;
- a first, a second and a third vertical conducting via (120, 121, 122) providing access to said input interface (2), electrically connected to said first, second and third current lines (117, 118, 119) respectively, such that the first vertical via (120) injects current $I_B$ into said first line (117), said second vertical via (121) injects current $I_A$ into said second line (118) and said third vertical via (122) injects current $I_{cin}$ into said third current line (119);

said second current line (118) generating a magnetic field in the vicinity of said first and second stacks (MTJ1, MTJ2) and being located at a distance d along the vertical axis of the soft layers in each of said first and second stacks (MTJ1, MTJ2);

said first current line (117) generating a magnetic field in the vicinity of said first stack (MTJ1) and being located at a distance 2xd along the vertical axis of the soft layer of said first stack (MTJ1);

said third current line (119) generating a magnetic field in the vicinity of said first and second stacks (MTJ1, MTJ2) and being located at a distance 2xd along the vertical axis of the soft layers in each of said first and second stacks (MTJ1, MTJ2);

said first current line (117) being electrically connected to said third current line (119) using a vertical interconnecting via (125) such that currents $I_B$ and $I_{cin}$ of said first and third lines (117, 119) are added together before being routed on the branch (123) of said third current line (119) generating a magnetic field in the vicinity of said second stack (MTJ2);

said second current line (118) being approximately perpendicular to said first and third current lines (117, 119) in the vicinity of said first stack (MTJ1) and said second current line (118) being approximately perpendicular to said third current line (119) in the vicinity of said second stack (MTJ2);

- a fourth current line (132) called the carry propagation line, belonging to said first metallisation level (N1);
- a fourth and a fifth vertical conducting via (135, 136) electrically connecting said fourth current line (132) to said second current line (118) through which current $I_A$ passes and to said branch (123) of said third current line through which the sum of currents $I_B + I_{Cin}$ passes respectively, such that $I_B + I_{Cin}$ and $I_A$ currents are added together before being routed on said fourth current line (132);
- a fifth current line (419) belonging to a metallisation level (N3) different from said first metallisation level (N1) and capable of generating a magnetic field in the vicinity of a magnetoresistive stack (MTJ1', MTJ2');
- - a sixth vertical conducting via (422) electrically connecting said fourth current line (132) to said fifth current line (419).

**14.** Adder (109) according to claim 13, **characterised in that** it comprises:

- a seventh vertical conducting via (438) electrically connected to said carry propagation line (132);
- a current limiter circuit (500) to limit the absolute value of the current circulating in said carry propagation line (132), said current limiter circuit (500) being connected to said propagation line (132) through said seventh conducting via (438).

**15.** Adder according to claim 14, **characterised in that** said current limiter circuit (500) comprises three PMOS transistors (501, 502, 503) and three NMOS transistors (504, 505, 506) mounted in series, the first PMOS transistor (501) and the third NMOS transistor (506) having their gates in common, the second PMOS transistor (502) and the second NMOS transistor (505) having their gates in common, the third PMOS transistor (503) and the first NMOS transistor (504) having their gates in common, and the common drain of the first NMOS transistor (504) and the third PMOS transistor (503) being connected to said carry propagation line (132) through said seventh vertical conducting via (438).

**Fig. 1**

**Fig. 2**

(a) MTJ SL IC HL

(b)

**Fig. 3**

**Fig. 4**

**Fig. 5**

**Fig. 6**

**Fig. 7**

**Fig. 8**

Fig. 9

Fig. 10

Fig. 11

**Fig. 12**

EP 2 269 309 B1

$A_0$    $B_0$    $A_1$    $B_1$

500

Vdd

501
502
503

$B_0$
$A_0$
$Cin_0$
$Cin_0$

438

132

+/- I

504
505
506

132

-4-    Cout$_1$

Vdd/2

$I_{A0} + I_{B0} + I_{Cin0}$

**Fig. 13**

600

IA>0

601

-E$_1$-

MTJ    604

602

IB>0

-E$_2$-

Itot    Y

X

603

I>0

-E$_3$-

605

**Fig. 14**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

* DE 10053206 C1